(19) **Europäisches Patentamt / European Patent Office / Office européen des brevets**

(11) **EP 3 446 386 B1**

(12) **EUROPÄISCHE PATENTSCHRIFT**

(45) Veröffentlichungstag und Bekanntmachung des Hinweises auf die Patenterteilung:
**08.11.2023 Patentblatt 2023/45**

(21) Anmeldenummer: **16726097.5**

(22) Anmeldetag: **31.05.2016**

(51) Internationale Patentklassifikation (IPC):
**H02H 1/00** (2006.01)

(52) Gemeinsame Patentklassifikation (CPC):
**H02H 1/0015**

(86) Internationale Anmeldenummer:
**PCT/EP2016/062271**

(87) Internationale Veröffentlichungsnummer:
**WO 2017/207029 (07.12.2017 Gazette 2017/49)**

(54) **STÖRLICHTBOGENERKENNUNGSEINHEIT**

FAULT-ARC IDENTIFICATION UNIT

UNITÉ DE DÉTECTION D'ARCS ÉLECTRIQUES PARASITES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**27.02.2019 Patentblatt 2019/09**

(73) Patentinhaber: **Siemens Aktiengesellschaft 80333 München (DE)**

(72) Erfinder:
• **WENZLAFF, Karsten 01097 Dresden (DE)**
• **MEYER, Jörg 01157 Dresden (DE)**
• **SCHEGNER, Peter 01259 Dresden (DE)**

(74) Vertreter: **Siemens Patent Attorneys Postfach 22 16 34 80506 München (DE)**

(56) Entgegenhaltungen:
WO-A1-2009/156513    US-A1- 2008 129 307
US-A1- 2011 019 444    US-B1- 6 654 219

**Beschreibung**

Die Erfindung betrifft eine Störlichtbogenerkennungseinheit, einen Leistungsschalter, einen Kurzschließer und ein Verfahren zur Störlichtbogenerkennung.

In Niederspannungsstromkreisen bzw. Niederspannungsanlagen respektive Niederspannungsnetzen, d.h. Stromkreise für Spannungen bis 1000 Volt Wechselspannung oder 1500 Volt Gleichspannung, sind Kurzschlüsse meist mit auftretenden Störlichtbögen, wie parallele oder serielle Störlichtbögen, verbunden. Besonders in leistungsstarken Verteil- und Schaltanlagen können diese bei einer nicht ausreichend schnellen Abschaltung zu verheerenden Zerstörungen von Betriebsmitteln, Anlagenteilen oder kompletten Schaltanlagen führen. Um einen länger andauernden und großflächigen Ausfall der Energieversorgung zu vermeiden und Personenschäden zu reduzieren, ist es erforderlich derartige Störlichtbögen, insbesondere stromstarke bzw. parallele Störlichtbögen, in wenigen Millisekunden zu erkennen und zu löschen. Konventionelle Schutzsysteme von Energieversorgungsanlagen (z.B. Sicherungen und Leistungsschalter) können unter den geforderten zeitlichen Anforderungen keinen zuverlässigen Schutz bieten.

Mit Leistungsschalter sind hier insbesondere Schalter für Niederspannung gemeint. Leistungsschalter werden, insbesondere in Niederspannungsanlagen, üblicherweise für Ströme von 63 bis 6300 Ampere eingesetzt. Spezieller werden geschlossene Leistungsschalter, wie Moulded Case Circuit Breaker, für Ströme von 63 bis 1600 Ampere, insbesondere von 125 bis 630 oder 1200 Ampere eingesetzt. Offene Leistungsschalter bzw. Luftleistungsschalter, wie Air Circuit Breaker, werden insbesondere für Ströme von 630 bis 6300 Ampere, spezieller von 1200 bis 6300 Ampere eingesetzt.

Leistungsschalter im Sinne der Erfindung können insbesondere eine elektronischen Auslöseeinheit, auch als Electronic Trip Unit, kurz ETU, bezeichnet, aufweisen.

Leistungsschalter überwachen den durch sie hindurchfließenden Strom und unterbrechen den elektrischen Strom bzw. Energiefluss zu einer Energiesenke bzw. einem Verbraucher, was als Auslösung bezeichnet wird, wenn Stromgrenzwerte oder Strom-Zeitspannengrenzwerte, d.h. wenn ein Stromwert für eine gewisse Zeitspanne vorliegt, überschritten werden. Die Ermittlung von Auslösebedingungen und das Auslösen eines Leistungsschalters kann mittels einer elektronischen Auslöseeinheit erfolgen.

Kurzschließer sind spezielle Einrichtungen zum Kurzschließen von Leitungen bzw. Stromschienen, um definierte Kurzschlüsse zum Schutz von Stromkreisen bzw. Anlagen herzustellen.

Konventionelle Störlichtbogendetektionssysteme werten die durch den Lichtbogen erzeugte Lichtemission aus und detektieren hiermit den Störlichtbogen.

Dies hat den Nachteil, dass parallel zu den elektrischen Leitungen bzw. Stromschienen Lichtwellenleiter bzw. optische Detektionssysteme verlegt werden müssen, um eventuell auftretende Störlichtbögen zu erkennen.

Die amerikanische Patentanmeldung US 2011/0019444 A1 offenbart ein Verfahren und eine Vorrichtung zum Regeln von Gleichstromlichtbogenfehlern. Mindestens ein Teil des Verfahrens wird von einer Steuerung ausgeführt, die mindestens einen Prozessor umfasst. In einer Ausführungsform umfasst das Verfahren das Analysieren einer Signatur eines Signals eines Leistungswandlers und das Bestimmen, ob ein Lichtbogenfehler vorliegt, basierend auf der Analyse der Signatur

Das amerikanische Patent US 6,654,219 B1 betrifft eine Fehlererkennungsvorrichtung für Stromleitungen. Es hat einen De tektor mit Sensoren zum Erkennen der Kategorie und des Ortes eines auftretenden Fehlers und eine Ausgabeeinheit zum Ausgeben eines eindeutigen Codes, der der erkannten Kategorie und dem erkannten Ort zugeordnet ist. Die Vorrichtung weist einen Detektor (24) mit einem Stromsensor (18) und einem Spannungssensor (46) zum Identifizieren einer Kategorie und eines Ortes eines auftretenden Fehlers auf. Der Detektor empfängt Eingaben von den Sensoren und vergleicht die Eingaben mit bekannten Lichtbogenfehlersignaturen und nachgebildeten Lichtbogenfehlersignaturen. Eine Ausgabeeinheit (30) ist vorgesehen, um einen eindeutigen Code auszugeben, der jeder erkannten unterschiedlichen Fehlerkategorie und Stelle zugeordnet ist. Der Sensor erkennt den Lichtbogenfehler und beendet den Fehler sicher und verhindert so das Auftreten eines Brandes in den Stromkreisen. Das Gerät erleichtert die Behebung des Fehlers in den Stromkreisen.

Die internationale Patentanmeldung WO 2009/156513 A1 offenbart ein Verfahren zum selektiven Auslösen von Leistungsschaltern (LSI, LS2, LS3) im Falle eines Kurzschlusses, bei dem ein vorgeordneter Leistungsschalter (LSI) und abgangsseitig mindestens ein nachgeordneter Leistungsschalter (LS2, LS3) vorgesehen sind, wobei der vorgeordnete Leistungsschalter (LSI) überwacht, ob der oder einer der nachgeordneten Leistungsschalter (LS2, LS3) bereits unter Bildung eines Schaltlichtbogens (5) dabei ist, seine Schaltkontakte zur Unterbrechung seines abgangsseitigen Stromkreises zu öffnen. Um sicher feststellen zu können, ob ein nachgeordneter Leistungsschalter (LS2, LS3) bereits dabei ist zu öffnen, wird vorgeschlagen, dass der vorgeordnete Leistungschalter (LSI) zur Feststellung eines abgangsseitigen Schaltlichtbogens (5) jeweils prüft, ob der ohmsche Widerstand (W) der durch einen Kurzschluss (4) gebildeten Kurzschlussschleife (6) zeitlich einen exponentiellen Verlauf aufweist, indem fortlaufend ein Exponent (b) berechnet und anhand des berechneten Exponenten (b) der Schaltlichtbogen (5) festgestellt wird, wenn der berechnete Exponent (b) einen vorgegebenen Schwellwert (S) überschreitet.

Die amerikanische Patentanmeldung US 2008/0129307 A1 offenbart ein Verfahren und Vorrichtungen zum Erfassen von Lichtbogenfehlern. Die Vorrichtung gemäß einer Ausführungsform umfasst: einen Hauptknoten (111) zum digitalen Erfassen eines Stromsignals und eines Spannungssignals an einem ersten Punkt in einem Verdrahtungssystem (131); einen Nebenknoten (122) zum digitalen Erfassen eines Stromsignals und eines Spannungssignals an einem zweiten Punkt im Verdrahtungssystem (131); und eine Erfassungseinheit zum Erfassen eines Lichtbogenfehlers in dem Verdrahtungssystem (131) durch Vergleichen der Stromsignale von dem Master-Knoten (111) und von dem Slave-Knoten (122), und Vergleichen der Spannungssignale vom Masterknoten (111) und vom Slaveknoten (122).

Aufgabe der vorliegenden Erfindung ist es, eine Möglichkeit zur Störlichtbogenerkennung anzugeben.

Diese Aufgabe wird durch eine Störlichtbogenerkennungseinheit mit den Merkmalen des Patentanspruchs 1, einen Leistungsschalter gemäß Patentanspruch 13, einen Kurzschließer gemäß Patentanspruch 14 und ein Verfahren mit den Merkmalen des Patentspruchs 15 gelöst.

Erfindungsgemäß ist vorgesehen, dass eine Störlichtbogenerkennungseinheit für einen elektrischen Stromkreis mindestens einen dem Stromkreis zugeordneten Spannungssensor, zur periodischen Ermittlung von elektrischen Spannungswerten des elektrischen Stromkreises,

mindestens einen dem Stromkreis zugeordneten Stromsensor, zur periodischen Ermittlung von elektrischen Stromgrößen des Stromkreises aufweist. Beide sind mit einer Auswerteeinheit verbunden, die derart ausgestaltet ist,

dass die elektrischen Spannungswerte einer ersten Störlichtbogenerkennungsfunktion wie in Anspruch 1 definiert zugeführt werden, die an Hand des Signalverlaufs der Spannung eine erste Störlichtbogenerkennung durchführt und bei betragsmäßiger Überschreitung eines ersten Schwellwertes (SW1) ein erstes Störlichtbogenerkennungssignal abgibt,

dass die elektrischen Spannungswerte und Stromgrößen einer zweiten Störlichtbogenerkennungsfunktion wie in Anspruch 1 definiert zugeführt werden,

die an Hand der Spannungswerte und Stromgrößen eine zweite Störlichtbogenerkennung durchführt und bei betragsmäßiger Überschreitung eines zweiten Schwellwertes (SW2) ein zweites Störlichtbogenerkennungssignal abgibt,

dass die beiden Störlichtbogenerkennungssignale einer Oder-Funktion zugeführt werden, so dass bei Vorliegen eines ersten oder zweiten Störlichtbogenerkennungssignales ein oderverknüpftes Störlichtbogenerkennungssignal als ausgangsseitiges Störlichtbogenerkennungssignal abgegeben wird.

Mit betragsmäßiger Überschreitung ist sowohl eine reine betragsmäßige Überschreitung eines Schwellwertes gemeint, als auch eine Überschreitung hinsichtlich eines positiven Schwellwertes oder/und eines negativen Schwellwertes, wobei jeweils der Betrag des Schwellwertes überschritten wird. Der Betrag des positiven Schwellwertes und des negativen Schwellwertes können identisch sein, allerdings auch voneinander abweichen.

Dies hat den besonderen Vorteil, dass eine umfassende Erkennung von Störlichtbögen ermöglicht wird, da mittels zweier Funktionen das Vorliegen solcher geprüft wird. Somit können verschiedenartige Störlichtbögen erfasst werden und ein umfassender Anlagenschutz realisiert werden.

Erfindungsgemäß ist der Stromkreis ein Niederspannungswechselstromkreis.

Dies hat den besonderen Vorteil, dass hier die Erfindung besonders wirkungsvoll eingesetzt werden kann.

Erfindungsgemäß ist die Auswerteeinheit derart ausgestaltet ist,

dass die elektrischen Stromgrößen einer dritten Störlichtbogenerkennungsfunktion zugeführt werden, die fortlaufend die Stromgröße oder deren Äquivalent mit einem dritten Schwellwert (SW3) vergleicht und bei dessen Überschreitung ein drittes Störlichtbogenerkennungssignal abgibt,

dass das oderverknüpfte Störlichtbogenerkennungssignal und das dritte Störlichtbogenerkennungssignal einer Und-Funktion zugeführt werden, so dass das ausgangsseitige Störlichtbogenerkennungssignal nur bei Vorliegen des dritten und des oderverknüpften Störlichtbogenerkennungssignales von der Störlichtbogenerkennungseinheit abgegeben wird.

Dies hat den besonderen Vorteil, dass ein weiteres Kriterium für das Vorliegen von Störlichtbogen vorliegt und so die fehlerhafte Abgabe eines Störlichtbogenerkennungssignals vermieden wird. Störlichtbögen treten häufig erst bei höheren Strömen auf. Dies wird erfindungsgemäß bei der Auswertung berücksichtigt.

In einer vorteilhaften Ausgestaltung der Erfindung werden die elektrischen Spannungswerte oder/und Stromgrößen mit einem festen Zeitabstand (dt) ermittelt.

Dies hat den besonderen Vorteil, dass eine besonders genaue Ermittlung von Störlichtbögen ermöglicht wird, da Werte mit regelmäßigem Abstand vorliegen und so die Störlichtbogenkriterien besonders gut ermittelt werden können.

In einer vorteilhaften Ausgestaltung der Erfindung wird fortlaufend aus zwei zeitlich aufeinanderfolgenden Spannungswerten eine Spannungsdifferenz ermittelt wird. Die Spannungsdifferenz wird durch die zeitliche Differenz (dt) der Spannungswerte dividiert. Der somit ermittelte Differenzenquotient (Dqun) wird, als Maß für die Änderung der Spannung nach der Zeit, an Stelle mit dem ersten mit einem vierten Schwellwert (SW4) betragsmäßig verglichen. Bei dessen Überschreitung wird ein erstes Störlichtbogenerkennungssignal abgegeben. Dies hat den besonderen Vorteil, dass eine einfache erste Ermittlungsmöglichkeit für Störlichtbögen zur Verfügung steht.

In einer vorteilhaften Ausgestaltung der Erfindung wird fortlaufend eine erste Hälfte einer ersten Anzahl Spannungswerte zu einer ersten Teilsumme (TS1) und die zweite Hälfte an Spannungswerten zu einer zweiten Teilsumme (TS2) aufsummiert wird. Eine Differenz (DU) beider Teilsummen wird ermittelt. Die Differenz wird betragsmäßig mit einem ersten Schwellwert (SW1) verglichen. Bei dessen Überschreitung wird ein erstes Störlichtbogenerkennungssignal abgegeben.

Dies hat den besonderen Vorteil, dass eine einfache, aber genauere Ermittlung von Störlichtbögen ermöglicht wird.

In einer vorteilhaften Ausgestaltung der Erfindung ist die Störlichtbogenerkennungseinheit derart ausgestaltet, dass die Spannungswerte mit einem Vielfachen der Frequenz des Niederspannungsstromkreises ermittelt werden oder mit einer Abtastfrequenz im Bereich von 2-100 kHz, insbesondere im Bereich 10 bis 40 oder 60 kHz, spezifischer bei 40-50 kHz.

Dies hat den besonderen Vorteil, dass eine optimale Anzahl an Spannungswerten für die erfindungsgemäße Auswertung vorliegt. Bei einer Netzfrequenz des Niederspannungsstromkreises von 50 oder 60 Hz liegen so ca. 1000 Spannungswerte pro Grundwelle der Netzfrequenz vor. Bei dieser Anzahl hat sich eine gute Erkennung von Störlichtbögen mit der Erfindung gezeigt.

In einer vorteilhaften Ausgestaltung der Erfindung, bei der Teilsummen ermittelt werden, ist die Auswerteeinheit derart ausgestaltet, dass die erste Anzahl durch ein Zeitfenster bestimmt ist. D.h. die Anzahl an aufzusummierenden Stromwerten wird durch ein zu verwendendes Zeitfenster bestimmt. Aus dem Zeitfenster, dass beispielsweise im Bereich von 0,1 bis 5 ms oder 10 ms liegen kann, insbesondere bei 1 ms liegen kann, ergibt sich ferner durch die verwendete Abtastfrequenz die erste Anzahl an Spannungswerten.

Dies hat den besonderen Vorteil, dass die Auswertung ausschnittsweise erfolgt und so eine besonders genaue Erkennung von Störlichtbögen ermöglicht wird.

In einer vorteilhaften Ausgestaltung der Erfindung, bei der Teilsummen ermittelt werden, ist die Auswerteeinheit derart ausgestaltet, dass für jeden ermittelten Spannungswert (u(k)) eine Differenzermittlung durchgeführt wird. D.h. die erfindungsgemäße Differenzermittlung wird fortlaufend für jeden neuen Spannungswert durchgeführt.

Dies hat den besonderen Vorteil, dass eine besonders zeitnahe und schnelle Ermittlung von Störlichtbögen ermöglicht wird.

In einer vorteilhaften Ausgestaltung der Erfindung, bei der Teilsummen ermittelt werden, ist die Auswerteeinheit derart ausgestaltet, dass die Differenz (DU) mit einem Faktor multipliziert wird, dessen Größe von der ersten Anzahl abhängig ist. Insbesondere ist der Faktor ein Produkt aus einer Konstanten und dem Kehrwert der ersten Anzahl.

Dies hat den besonderen Vorteil, dass eine normierte Differenz (DU) zur Verfügung steht, die mit einem normierten ersten Schwellwert verglichen wird. Somit wird eine Auswertung mit objektivem Vergleich ermöglicht.

In einer vorteilhaften Ausgestaltung der Erfindung, bei der Teilsummen ermittelt werden, ist die Auswerteeinheit derart ausgestaltet, dass fortlaufend eine zweite Anzahl Differenzen (DU) zu einer Differenzensumme (DS) aufsummiert wird, an Stelle der Differenz (DU) die Differenzsumme (DS) mit dem ersten Schwellwert (SW1) verglichen wird und bei dessen betragsmäßiger Überschreitung ein erstes Störlichtbogenerkennungssignal abgegeben.

Dies hat den besonderen Vorteil, dass eine noch genauere Ermittlung von Störlichtbögen ermöglicht wird, da sich die Differenzen, die bei Störlichtbögen auftreten, summieren. Damit steht ein genauerer bzw. größerer Wert für den Schwellwertvergleich zur Verfügung.

Erfindungsgemäß wird eine Lichtbogenspannung berechnet.

In einer vorteilhaften Ausgestaltung der Erfindung, bei der fortlaufend ein erstes Wertepaar eines Spannungswertes und einer Stromgröße zu einem ersten Zeitpunkt und ein zweites Wertepaar eines Spannungswertes und einer Stromgröße zu einem zweiten Zeitpunkt vorliegen, wird aus den zwei Wertepaaren eine Lichtbogenspannung (Ulb) berechnet, die mit einem zweiten Schwellwert (SW2) verglichen wird. Bei dessen betragsmäßiger Überschreitung wird ein zweites Störlichtbogenerkennungssignal abgegeben.

Dies hat den besonderen Vorteil, dass eine einfache und sichere Möglichkeit zur Störlichtbogenerkennung gegeben ist.

In einer vorteilhaften Ausgestaltung der Erfindung, bei aus Wertepaaren eine Lichtbogenspannung berechnet wird, liegt ein drittes Wertepaar eines Spannungswertes (u3) und einer Stromgröße zu einem dritten Zeitpunkt vor.

Aus den drei Wertepaaren wird eine Lichtbogenspannung (Ulb) berechnet, die mit dem zweiten Schwellwert (SW2) verglichen wird. Bei dessen betragsmäßiger Überschreitung wird ein Störlichtbogenerkennungssignal abgegeben.

Dies hat den besonderen Vorteil, dass einen genauere und noch sichere Möglichkeit zur Störlichtbogenerkennung gegeben ist. In einer vorteilhaften Ausgestaltung der Erfindung ist die elektrische Stromgröße entweder ein elektrischer Stromwert ($i_m$) oder ein Wert für die Änderung des elektrischen Stromes nach der Zeit ($i'_m$). Dies hat den

besonderen Vorteil, dass nur eine Stromgröße, entweder Stromwert oder Änderung des elektrischen Stromes nach der Zeit, respektive die Ableitung des Stromes nach der Zeit, ermittelt werden braucht. Beispielsweise kann vorteilhaft zur Ermittlung der Stromgröße eine Rogowskispule verwendet werden, womit die Änderung des Stromes nach der Zeit erfasst wird.

In einer vorteilhaften Ausgestaltung der Erfindung wird im Falle der Ermittlung des elektrischen Stromwertes ($i_m$) daraus ein Wert für die Änderung des elektrischen Stromes nach der Zeit ($i'_m$), respektive die erste Ableitung des Stromwertes nach der Zeit, ermittelt oder im Falle der Ermittlung des Wertes für die Änderung des elektrischen Stromes nach der Zeit ($i'_m$) daraus der elektrische Stromwert ($i_m$) ermittelt. Ein Wertepaar weist damit vorteilhafterweise einen Spannungswert ($u_m$), einen Stromwert ($i_m$) und einen Wert für die Änderung des Stromes nach der Zeit ($i'_m$) auf, womit sich die Lichtbogenspannung (Ulb) berechnen lässt.

In einer vorteilhaften Ausgestaltung der Erfindung, bei aus Wertepaaren eine Lichtbogenspannung berechnet wird, ist die Auswerteeinheit derart ausgestaltet, dass die Berechnung der Lichtbogenspannung (Ulb) mit Hilfe einer Differentialgleichung oder deren Lösung durchgeführt wird.

Dies hat den besonderen Vorteil, dass eine umfassende Berechnungsmöglichkeit unter Berücksichtigung vieler Parameter eines realen Stromkreises zur Verfügung steht.

In einer vorteilhaften Ausgestaltung der Erfindung, bei aus Wertepaaren eine Lichtbogenspannung berechnet wird, liegt der erste Zeitpunkt zeitlich vor dem zweiten Zeitpunkt. Alternativ liegt der zweite Zeitpunkt zeitlich vor dem dritten Zeitpunkt. Alternativ liegt der erste Zeitpunkt zeitlich vor dem zweiten Zeitpunkt liegt und dieser zeitlich vor dem dritten Zeitpunkt.

Dies hat den besonderen Vorteil, dass eine besonders genaue Ermittlung einer Störlichtbogenspannung ermöglicht wird.

In einer vorteilhaften Ausgestaltung der Erfindung umfasst ein Wertesatz mehrere Wertepaare und aus mindestens zwei Wertesätzen wird eine Lichtbogenspannung berechnet. Diese wird mit dem zweiten Schwellwert (SW2) verglichen wird und bei dessen betragsmäßiger Überschreitung wird das zweite Störlichtbogenerkennungssignal abgegeben.

In einer vorteilhaften Ausgestaltung der Erfindung sind die Sensoren extern angeordnet sein und müssen nicht im Gehäuse der Störlichtbogenerkennungseinheit angeordnet sein. Die periodische bzw. fortlaufende Ermittlung von Wertepaaren eines Spannungswertes und einer Stromgröße, insbesondere zu einem Zeitpunkt, kann beispielsweise durch eine Abtastung der entsprechenden Werte erfolgen.

Dies hat den besonderen Vorteil, dass eine flexible Ermittlung von Störlichtbögen gegeben ist.

In einer vorteilhaften Ausgestaltung der Erfindung erfolgt die Berechnung der Lichtbogenspannung aus drei Wertesätzen. Dies hat den besonderen Vorteil, dass eine besonders genaue Ermittlung der Lichtbogenspannung ermöglicht wird, um so sicherer Störlichtbögen zu erkennen.

In einer vorteilhaften Ausgestaltung der Erfindung ist die Auswerteeinheit derart ausgestaltet, dass die Berechnung der Lichtbogenspannung ($U_{lb}$) mit Hilfe einer Integralgleichung oder deren Lösung durchgeführt wird.

Dies hat den besonderen Vorteil, dass eine umfassende Berechnungsmöglichkeit unter Berücksichtigung vieler Parameter eines realen Stromkreises zur Verfügung steht.

In einer vorteilhaften Ausgestaltung der Erfindung ist die Auswerteinheit derart ausgestaltet, dass ein Wertepaar nur einem Wertesatz zugeordnet ist.

Dies hat den besonderen Vorteil, dass eine besonders genaue Berechnung ermöglicht wird, da Redundanzen der ermittelten Wertepaare in verschiedenen Wertesätzen ausgeschlossen werden.

In einer vorteilhaften Ausgestaltung der Erfindung ist die Auswerteinheit derart ausgestaltet, dass jeder Wertesatz eine feste Anzahl Wertepaare aufweist.

Dies hat den besonderen Vorteil, dass eine einfache Möglichkeit zur zyklischen Berechnung der Lichtbogenspannung gegeben ist, da in jedem Durchgang die gleiche Anzahl Wertepaare ausgewertet werden kann.

In einer vorteilhaften Ausgestaltung der Erfindung ist die Auswerteinheit derart ausgestaltet, dass fortwährend die Wertepaare einem Wertesatz zugeordnet werden, bis die feste Anzahl Wertepaare erreicht ist, und die nachfolgenden Wertepaare dem nächsten Wertesatz zugeordnet werden.

Dies hat den besonderen Vorteil, dass sowohl eine genauere als auch zyklische Ermittlung der Lichtbogenspannung ermöglicht wird.

In einer vorteilhaften Ausgestaltung der Erfindung ist die Auswerteeinheit derart ausgestaltet, dass für die Berechnung der Lichtbogenspannung ($U_{lb}$) aus einem Wertesatz mindestens einer der folgenden Terme gebildet wird:

a) ein Zeit-Spannungssummen-Produkt (us), gebildet aus dem Zeitabstand (dt) und der Summe der Spannungswerte (um), wobei die Summe der Spannungswerte durch den halben ersten Spannungswert, den halben letzten Spannungswert und der Summe der übrigen Spannungswerte des Wertesatzes gebildet wird;

b) ein Zeit-Stromsummen-Produkt (is), gebildet aus dem Zeitabstand (dt) und der Summe der Stromwerte, wobei die Summe des Stromwerte durch den halben ersten Stromwert, den halben letzten Stromwert und der Summe des übrigen Stromwerte des Wertesatzes gebildet wird;

c) ein Zeit-Stromänderungswert-Produkt (i's), gebildet aus dem Zeitabstand (dt) und der Summe der Werte für die Änderung des Stromes nach der Zeit, wobei die Summe der Werte für die Änderung des Stromes nach der Zeit durch den halben ersten Wert, den halben letzten Wert und der Summe der übrigen Werte des Wertesatzes gebildet wird;

d) ein Zeit-Vorzeichenwert-Produkt (ss), gebildet aus dem Zeitabstand (dt) und der Summe der Vorzeichenwerte der Stromwerte, wobei ein Vorzeichenwert den Wert plus Eins bei positiven Stromwert, minus Eins bei negativen Stromwert und Null bei einem Stromwert von Null annimmt, wobei die Summe der Vorzeichenwerte aus dem halben Vorzeichenwert des ersten Stromwertes, dem halben Vorzeichenwert des letzten Stromwertes und der Summe der Vorzeichenwerte der übrigen Stromwerte gebildet wird.

Dies hat den besonderen Vorteil, dass mit mindestens einem dieser Terme eine Ermittlung der Störlichtbogenspannung ermöglicht wird.

In einer vorteilhaften Ausgestaltung der Erfindung ist die Auswerteinheit derart ausgestaltet, dass ein Vorzeichenwert des Stromwertes den Wert Null annimmt, wenn der Betrag des Spannungswertes dieses Wertepaares einen zweiten Schwellwert unterschreitet. D.h. das Ergebnis der Vorzeichenfunktion bzw. Signumfunktion wird immer Null gesetzt, wenn der Betrag des zeitgleichen Spannungswerts kleiner-gleich dem zweiten Schwellwert ist. Als typischer Schwellwert kann hierfür z.B. ein Anoden-Kathodenspannungsfall von etwa 20 V angenommen werden, da davon ausgegangen werden kann, dass unter diesem zweiten Schwellwert kein Lichtbogen entstehen kann.

Durch Einführung dieser Nebenbedingung für die Berechnung der Signumfunktion werden bei der Lichtbogenzündung Instabilitäten in der Berechnung der Lichtbogenspannung wesentlich minimiert. Dies hat den besonderen Vorteil, dass insbesondere bei und nach der Lichtbogenzündung genauere Berechnungsergebnisse vorliegen und somit eine bessere Störlichtbogenerkennung ermöglicht wird.

In einer vorteilhaften Ausgestaltung der Erfindung ist die Auswerteeinheit derart ausgestaltet, dass für die Berechnung der Lichtbogenspannung ($U_{lb}$) für zwei aufeinanderfolgende Wertesätze jeweils die folgenden Terme gebildet werden:

ein erstes (us1) und ein zweites (us2) Zeit-Spannungssummen-Produkt,
ein erstes (is1) und ein zweites (is2) Zeit-Stromsummen-Produkt,
ein erstes (i's1) und ein zweites (i's2) Zeit-Stromänderungswert-Produkt,
ein erstes (ss1) und ein zweites (ss2) Zeit-Vorzeichenwert-Produkt berechnet wird.

Dies hat den besonderen Vorteil, dass eine einfache, insbesondere integrierende, Ermittlung der Störlichtbogenspannung ermöglicht wird.

In einer vorteilhaften Ausgestaltung der Erfindung ist die Auswerteeinheit derart ausgestaltet, dass für die Berechnung der Lichtbogenspannung ($U_{lb}$) für drei aufeinanderfolgende Wertesätze jeweils die folgenden Terme gebildet werden:

ein erstes (us1), ein zweites (us2) und ein drittes (us3) Zeit-Spannungssummen-Produkt,
ein erstes (is1), ein zweites (is2), und ein drittes (is3) Zeit-Stromsummen-Produkt,
ein erstes (i's1), ein zweites (i's2)und ein drittes (i's3) Zeit-Stromänderungswert-Produkt,
ein erstes (ss1), ein zweites (ss2) und ein drittes (ss3) Zeit-Vorzeichenwert-Produkt berechnet wird.

Dies hat den besonderen Vorteil, dass eine einfache und genauere, insbesondere integrierende, Ermittlung der Störlichtbogenspannung ermöglicht wird.

In einer vorteilhaften Ausgestaltung der Erfindung ist die Auswerteeinheit derart ausgestaltet, dass für die Berechnung der Lichtbogenspannung ($U_{lb}$) mindestens einer der folgenden Terme gebildet wird:

ein erstes Produkt (P1), gebildet aus dem dritten Zeit-Spannungssummen-Produkt (us3) und dem zweiten Zeit-Stromsummen-Produkt (is2),
ein zweites Produkt (P2), gebildet aus dem zweiten Zeit-Spannungssummen-Produkt (us2) und dem dritten Zeit-Stromsummen-Produkt (is3),
ein drittes Produkt (P3), gebildet aus dem zweiten Zeit-Stromänderungswert-Produkt (i's2) und dem ersten Zeit-Stromsummen-Produkt (is1),
ein viertes Produkt (P4), gebildet aus dem ersten Zeit-Stromänderungswert-Produkt (i's1) und dem zweiten Zeit-Stromsummen-Produkt (is2),
ein fünftes Produkt (P5), gebildet aus dem zweiten Zeit-Spannungssummen-Produkt (us2) und dem ersten Zeit-Stromsummen-Produkt (is1),

ein sechstes Produkt (P6), gebildet aus dem ersten Zeit-Spannungssummen-Produkt (us1) und dem zweiten Zeit-Stromsummen-Produkt (is2),

ein siebtes Produkt (P7), gebildet aus dem dritten Zeit-Stromänderungswert-Produkt (i's3) und dem zweiten Zeit-Stromsummen-Produkt (is2),

ein achtes Produkt (P8), gebildet aus dem zweiten Zeit-Stromänderungswert-Produkt (i's2) und dem dritten Zeit-Stromsummen-Produkt (is3),

ein neuntes Produkt (P9), gebildet aus dem ersten Zeit-Vorzeichenwert-Produkt (ss1) und dem zweiten Zeit-Stromsummen-Produkt (is2),

ein zehntes Produkt (P10), gebildet aus dem zweiten Zeit-Vorzeichenwert-Produkt (ss2) und dem ersten Zeit-Stromsummen-Produkt (is1),

ein elftes Produkt (P11), gebildet aus dem zweiten Zeit-Vorzeichenwert-Produkt (ss2) und dem dritten Zeit-Stromsummen-Produkt (is3),

ein zwölftes Produkt (P12), gebildet aus dem dritten Zeit-Vorzeichenwert-Produkt (ss3) und dem zweiten Zeit-Stromsummen-Produkt (is2),

eine erste Differenz (D1), dessen Minuend das erste Produkt (P1) und dessen Subtrahend das zweite Produkt (P2) ist,

eine zweite Differenz (D2), dessen Minuend das dritte Produkt (P3) und dessen Subtrahend das vierte Produkt (P4) ist,

eine dritte Differenz (D3), dessen Minuend das fünfte Produkt (P5) und dessen Subtrahend das sechste Produkt (P6) ist,

eine vierte Differenz (D4), dessen Minuend das siebte Produkt (P7) und dessen Subtrahend das achte Produkt (P8) ist

eine fünfte Differenz (D5), dessen Minuend das neunte Produkt (P9) und dessen Subtrahend das zehnte Produkt (P10) ist,

eine sechste Differenz (D6), dessen Minuend das elfte Produkt (P11) und dessen Subtrahend das zwölfte Produkt (P12) ist,

ein dreizehntes Produkt (P13), gebildet aus der ersten Differenz (D1) und der zweiten Differenz (D2),

ein vierzehntes Produkt (P14), gebildet aus der dritten Differenz (D3) und der vierten Differenz (D4),

ein fünfzehntes Produkt (P15), gebildet aus der fünften Differenz (D5) und der vierten Differenz (D4),

ein sechzehntes Produkt (P16), gebildet aus der sechsten Differenz (D6) und der zweiten Differenz (D2),

eine siebte Differenz (D7), dessen Minuend das dreizehnte Produkt (P13) und dessen Subtrahend das vierzehnte Produkt (P14) ist,

eine achte Differenz (D8), dessen Minuend das fünfzehnte Produkt (P15) und dessen Subtrahend das sechzehnte Produkt (P16) ist.

Dies hat den besonderen Vorteil, dass mit mindestens einem dieser Terme eine Ermittlung, insbesondere auf einem integrierenden Ansatz beruhende, der Störlichtbogenspannung ermöglicht wird.

In einer vorteilhaften Ausgestaltung der Erfindung ist die Auswerteeinheit derart ausgestaltet, dass die Lichtbogenspannung (Ulb) ein Quotient ist, dessen Dividend Terme der siebten Differenz (D7) aufweist und dessen Divisor Terme der achten Differenz (D8) aufweist.

Dies hat den besonderen Vorteil, dass eine sehr genaue Ermittlung einer Störlichtbogenspannung ermöglicht wird.

In einer vorteilhaften Ausgestaltung der Erfindung ist die Auswerteeinheit derart ausgestaltet, dass die Lichtbogenspannung (Ulb) auf den Wert Null gesetzt wird, wenn die Summe des ersten (ss1), zweiten (ss2) und dritten (ss3) Zeit-Vorzeichenwert-Produkts gleich Null ist.

Dies hat den besonderen Vorteil, dass unzulässige Berechnungsergebnisse bei der Berechnung der Lichtbogenspannung vermieden werden. Diese können Auftreten, wenn die drei Zeit-Vorzeichenwert-Produkte (ss1, ss2, ss3) jeweils Null sind. In diesem Fall wird die Lichtbogenspannung auf den Wert Null gesetzt.

Erfindungsgemäß ist ferner ein Leistungsschalter für einen elektrischen Stromkreis, insbesondere Niederspannungsstromkreis, vorgesehen. Dieser weist eine erfindungsgemäße Störlichtbogenerkennungseinheit auf. Diese ist mit dem Leistungsschalter verbunden, wobei diese derart ausgestaltet sind, dass bei Abgabe eines Störlichtbogenerkennungssignals der Leistungsschalter auslöst, d.h. den elektrischen Stromkreis unterbricht. Somit kann eine Löschung des Störlichtbogens erreicht werden. Weist der Leistungsschalter eine elektronische Auslöseeinheit auf, kann eine sehr schnelle Auslösung des Leistungsschalters bei vorliegen eines Störlichtbogenerkennungssignals erreicht werden.

Dies hat den besonderen Vorteil, dass ein Leistungsschalter um eine weitere, vorteilhafte Funktionalität zum Schutz elektrischer Anlagen erweitert wird. Die Erkennung und Abschaltung von Störlichtbögen erfolgt dabei vorteilhaft in einem Gerät. Gegebenenfalls lassen sich vorhandene Baugruppen, wie Spannungs- oder/und Stromsensoren, Netzteil, Mikroprozessoren für die Auswerteeinheit, etc. mitverwenden und so Synergien erzielen.

Erfindungsgemäß ist ferner ein Kurzschließer, aufweisend eine Störlichtbogenerkennungseinheit die mit dem Kurzschließer verbunden ist, vorgesehen. Diese sind derart ausgestaltet, dass bei Abgabe eines Störlichtbogenerkennungssignals der Kurzschließer den elektrischen Stromkreis kurzschließt, um ein Löschen des Störlichtbogens zu bewirken.

Dies hat den besonderen Vorteil, dass eine einfache, schnelle und wirksame Möglichkeit zum Löschen von Störlichtbögen zur Verfügung steht.

Erfindungsgemäß ist des Weiteren ein Verfahren zur Störlichtbogenerkennung für einen elektrischen Stromkreis vorgesehen, bei dem periodisch elektrische Spannungswerte und Stromgrößen des elektrischen Stromkreises ermittelt werden, die elektrischen Spannungswerte einer ersten Störlichtbogenerkennungsfunktion zugeführt werden, die an Hand des Signalverlaufs der Spannung eine erste Störlichtbogenerkennung wie in Anspruch 15 definiert durchführt und bei betragsmäßiger Überschreitung eines Schwellwertes (SW1) ein erstes Störlichtbogenerkennungssignal abgibt. Die elektrischen Spannungswerte und Stromgrößen werden ferner einer zweiten Störlichtbogenerkennungsfunktion wie in Anspruch 15 definiert zugeführt, die an Hand der Spannungswerte und Stromgrößen eine zweite Störlichtbogenerkennung durchführt und bei betragsmä-βiger Überschreitung eines zweiten Schwellwertes (SW2) ein zweites Störlichtbogenerkennungssignal abgibt. Die beiden Störlichtbogenerkennungssignale werden einer Oder-Funktion zugeführt, so dass bei Vorliegen eines ersten oder zweiten Störlichtbogenerkennungssignales ein oderverknüpftes Störlichtbogenerkennungssignal als ausgangsseitiges Störlichtbogenerkennungssignal abgegeben wird.

Dies hat den besonderen Vorteil eines einfachen Verfahrens zur Störlichtbogenerkennung.

Alle Ausgestaltungen und Merkmale der Erfindung bewirken eine Verbesserung der Erkennung von Störlichtbögen bzw. deren Löschung.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Hierbei zeigt:

Figur 1 ein Diagramm des zeitlichen Spannungs- und Stromverlaufes nach Lichtbogenzündung

Figur 2 ein Ersatzschaltbild eines elektrischen Stromkreises

Figur 3 ein erste Ablaufdiagramm zur Störlichtbogenerkennung

Figur 4 ein Blockschaltbild einer erfindungsgemäßen Lösung

Figur 5 eine erste Darstellung zur Erläuterung des Einsatzes der Erfindung

Figur 6 eine zweite Darstellung zur Erläuterung des Einsatzes der Erfindung

Figur 7 eine dritte Darstellung zur Erläuterung des Einsatzes der Erfindung

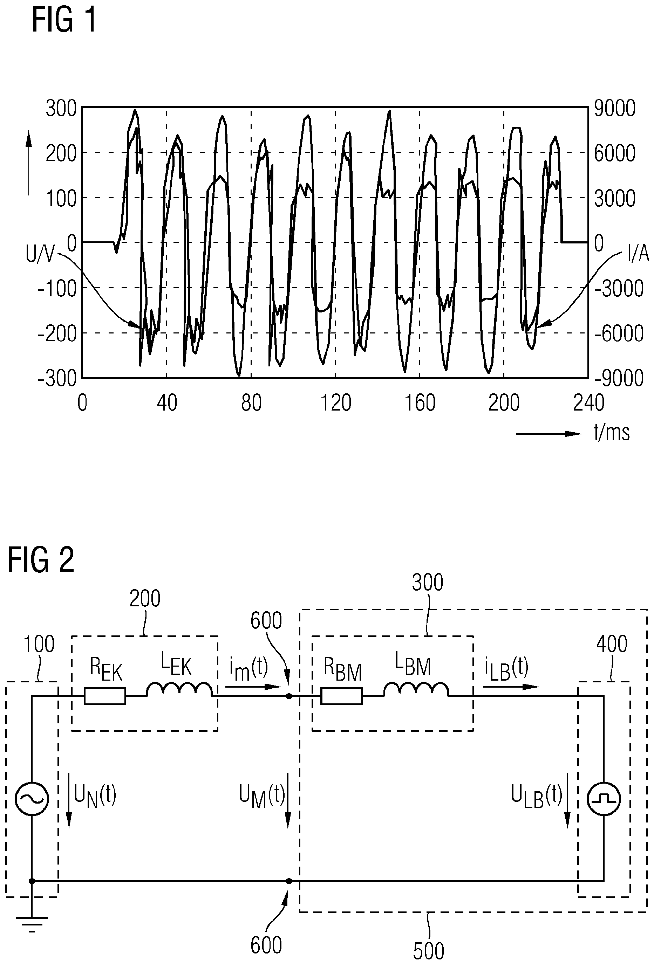

In einem Stromkreis bzw. Netz, in dem ein Störlichtbogen brennt, kann ein Strom- und Spannungsverlauf gemessen werden, der einen signifikanten Verlauf aufweist. Ein typischer Spannungs- und Stromverlauf für einen Störlichtbogen ist in Figur 1 dargestellt. Diese zeigt eine Darstellung eines Diagramms, in dem der zeitliche Verlauf der elektrischen Spannung U und des elektrischen Stromes I nach Zündung eines Lichtbogens bzw. Störlichtbogens, insbesondere parallelen Störlichtbogen, in einem elektrischen Stromkreis, insbesondere Niederspannungsstromkreis, dargestellt ist.

Auf der horizontalen X-Achse ist die Zeit t in Millisekunden (ms) dargestellt. Auf der vertikalen Y-Achse ist auf der linken Skalierung die Größe der elektrischen Spannung U in Volt (V) abgebildet. Auf der rechten Skalierung ist die Größe des elektrischen Stromes I in Ampere (A) abgebildet.

Nach Lichtbogenzündung verläuft der Strom I annähernd sinusförmig. Die Spannung U verläuft stark verzerrt, etwa "zackenförmig", mit schnellen Spannungsänderungen. Grob interpretiert ist der Spannungsverlauf in erster Näherung rechteckförmig, an Stelle eines üblicherweise sinusförmigen Verlaufs. Abstrahiert betrachtet, lässt sich im Spannungsverlauf eine Rechteckform erkennen, die auf dem Plateau einen hoch stochastischen Anteil aufzeigt. Die Rechteckform ist dadurch gekennzeichnet, dass es bei der Lichtbogenzündung und in den nachfolgenden Spannungsnulldurchgängen der Wechselspannung zu signifikant erhöhten Spannungsänderungen kommt, die folgend als Spannungssprung bezeichnet werden, da der Anstieg der Spannungsänderung im Vergleich zu einem sinusförmigen Spannungsverlauf wesentlich größer ist.

Im Gegensatz zum Spannungsverlauf weist der Stromverlauf von einem Störlichtbogen einen nahezu sinusförmigen Verlauf auf. Zum Zeitpunkt der Lichtbogenzündung kommt es jedoch zu einer Reduzierung des Stromanstiegs, die sich mit der physikalischen, strombegrenzenden Wirkung von Lichtbögen begründen lässt. Zusätzlich tritt eine signifikante Anstiegsänderung im Stromverlauf in jedem weiteren Stromnulldurchgang nach einer Lichtbogenzündung auf.

Erfindungsgemäß sollen derartige Spannungsänderungen bzw. Spannungssprünge zur Störlichtbogenerkennung verwendet werden. Ferner soll die Lichtbogenspannung berechnet werden. Die Erkennung soll dabei erfindungsgemäß durch mindestens diese zwei unterschiedlichen Ermittlungsmethoden durchgeführt werden.

Hierzu werden periodisch, mit beispielsweise einer festen Abtastzeit bzw. Abtastfrequenz fa Spannungswerte und Stromgrö-βen eines elektrischen Stromkreises ermittelt, erfasst, abgetastet bzw. gemessen. Dabei sollte die Abtastfrequenz bzw. Meßfrequenz ein Vielfaches der Frequenz der gemessenen Wechselgrößen betragen. Beispielsweise könnte bei üblichen Stromnetzen, mit beispielsweise 50Hz bzw. 60Hz Netzfrequenz, die Meßfrequenz im Kilohertz-Bereich liegen, beispielsweise zwischen 1 und 200 kHz, spezifischer im Bereich 10 bis 40 oder 60 kHz, insbesondere bei 40-50 kHz.

Fortlaufend bzw. periodisch werden diese elektrische Spannungswerte und elektrische Stromwerte ermittelt, beispielsweise mit je einem Sensor. Dabei kann beispielsweise der elektrische Strom direkt gemessen werden. Alternativ kann auch die Änderung des Stromes nach der Zeit gemessen werden.

Im Falle der Messung des elektrischen Stromes $i_m$ kann daraus die Änderung des Stromes nach der Zeit $i'_m$ ermittelt werden, beispielsweise durch Differentiation des Stromwertes $i_m$.

Im Falle der Messung der Änderung des elektrischen Stromes nach der Zeit $i'_m$ kann daraus der elektrische Strom $i_m$ ermittelt werden, beispielsweise durch Integration der Änderung des elektrischen Stromes nach der Zeit $i'_m$. Die Messung der Änderung des elektrischen Stromes nach der Zeit $i'_m$ kann beispielsweise mit einer Rogowskispule erfolgen. Im Falle sinusförmiger Ströme im Stromkreis ist die Integration besonders einfach zu realisieren, da das Intergral vom Sinus ein Cosinus und vom Cosinus ein Sinus ist.

Ebenso kann der Stromwert $i_m$ und die Änderung des Stromes nach der Zeit $i'_m$ auch parallel, z.B. mit 2 Sensoren, gemessen werden. Damit erübrigt sich eine Umrechnung.

Mit einem zeitlichen Abstand, beispielsweise einem festen zeitlichen Abstand dt (Abtastfrequenz), werden immer wieder Spannungswerte $u_m$ und Stromwerte $i_m$ bzw. Spannungswerte $u_m$ und Werte für die Änderung des elektrischen Stromes nach der Zeit $i'_m$ ermittelt.

Dabei werden beispielsweise ein Spannungswert und eine Stromgröße jeweils zu einem, insbesondere gleichen, Zeitpunkt ermittelt.

Für die erste Störlichtbogenfunktion kann beispielsweise mit zwei fortlaufend ermittelten Spannungswerten (um, um-1) eine Differenzberechnung durchgeführt werden, wobei ein Differenzenquotient (Dqun) für jeden Abtastwert der Spannung (um) berechnet wird. Dazu wird die Spannungsdifferenz des aktuellen Spannungsabtastwertes (um) zum vorhergehenden Spannungsabtastwert (um-1) gebildet. Diese Spannungsdifferenz (dun) wird durch die zeitliche Differenz (dt), d.h. dt = tn - tn-1, der Spannungsabtastwerte (um, um-1) dividiert, um so den Differenzenquotienten (Dqun) gemäß Formel 1 zu erhalten.

$$\mathrm{Dqun} = \frac{u_m - u_{m-1}}{t_n - t_{n-1}} = \frac{\mathrm{dun}}{\mathrm{dt}}$$

Dieser Differenzenquotient (Dqun) wird als Maß für die Änderung der Spannung nach der Zeit an Stelle des ersten Schwellwertes mit einem vierten Schwellwert (SW4) verglichen. Bei Erfüllung der Schwellwertbedingung erfolgt ein erstes Störlichtbogenerkennungssignal.

Alternativ kann auch vom vorhergehenden Spannungsabtastwert (um-1) der aktuelle Spannungsabtast (um) abgezogen werden (dun = (um-1) - (um)). Dadurch ändert sich lediglich das Vorzeichen des Differenzenquotienten. Bei einem Vergleich, beim dem nicht der Betrag mit dem Schwellwert verglichen werden, sondern die Absolutwerte, ist dementsprechend auch das Vorzeichen des Schwellwertes zu beachten und anzupassen.

Beispielsweise wurden die Spannungswerte 30 Volt (um-1) und 50 Volt (um) mit dem zeitlichen Abstand von 20 ps, was einer Abtastfrequenz von 50 KHz entspricht, gemessen.

$$\mathrm{Dqun} = \frac{50\,\mathrm{Volt} - 30\,\mathrm{Volt}}{20\,\mu s} = 1\,\frac{\mathrm{V}}{\mu s}$$

Der erste Schwellwert könnte beispielsweise bei 0,5 V/ps liegen.

Der ermittelte Differenzenquotient 1 V/ps liegt über den 0,5 V/$\mu$s. Somit wird ein erstes Störlichtbogenerkennungssignal abgegeben.

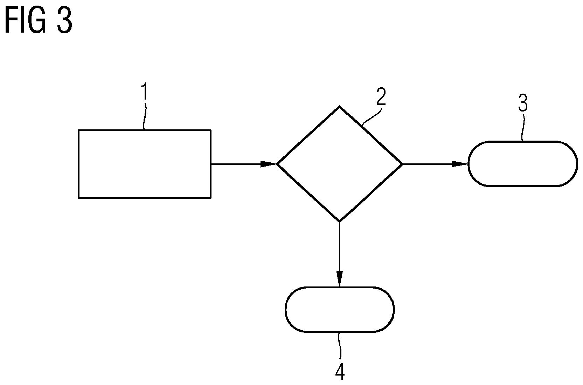

Eine entsprechende Auswertung ist in Figur 3 dargestellt. Gemäß Figur 3 erfolgt in einem ersten Schritt (1) die fortlaufende Berechnung des Differenzenquotienten Spannung (Dqun). Dieser wird in einem zweiten Schritt (2) mit dem vierten Schwellwert (SW4) verglichen. Erfolgt eine betragsmäßige Überschreitung des vierten Schwellwertes (SW4) erfolgt in einem dritten Schritt (3) die Abgabe eines ersten Störlichtbogenerkennungssignals. Ist der vierte Schwellwert (SW4) nicht überschritten, kann in einem vierten Schritt (4) die Meldung, dass kein Störlichtbogen bzw. kein brennender Störlichtbogen vorhanden ist, erfolgen.

Die Berechnung kann fortlaufend durchgeführt werden.

Alternativ kann die erste Störlichtbogenfunktion auch mittels einer Teilsummenberechnung durchgeführt werden. Erfindungsgemäß soll der Spannungssprung bei der Lichtbogenzündung und in jedem darauf folgenden Spannungsnulldurchgang erkannt werden um einen Störlichtbogen zu detektieren. Ein wesentlicher Vorteil bei der Extraktion dieser Signaleigenschaft im Spannungsverlauf ist das periodische Auftreten. Somit kann eine zusätzliche Detektionssicherheit erreicht werden, wenn gewollt oder ungewollt das erste Auftreten der Signaleigenschaft bei der Lichtbogenzündung nicht zu einer Detektion des Störlichtbogens führt.

Für die Extraktion dieser Signaleigenschaft soll erfindungsgemäß eine Summation mit Differenzberechnung verwendet werden, die als W-RU und in einer Ausgestaltung als W-RUs Verfahren bezeichnet werden soll.

Die Auswertung erfolgt dahingehend, dass eine Differenz bzw. ein Spannungssprung DU eingeführt wird. Dieser wird wie folgt ermittelt, wobei die Spannungswerte um bzw. $u_m$ im Folgenden auch in Abhängigkeit vom Zeitpunkt als u(k) bzw. u(n) gekennzeichnet sind:

$$DU(n) \;=\; \sum_{k=n-(j-1)}^{k=n-\frac{j}{2}} u(k) \;\;-\;\; \sum_{k=n-(\frac{j}{2}-1)}^{k=n} u(k) \qquad (1)$$

wobei:

u(k)      Spannungswert zum (zurückliegenden) Zeitpunkt k

u(n)      Spannungswert zum aktuellen Zeitpunkt n

DU(n)   Differenz zum aktuellen Zeitpunkt n

j          erste Anzahl, d.h. Anzahl an Zeitpunkten bzw. Abtastwerten die für die Berechnung der Differenz verwendet werden

Mit der obigen Formel wird für einen aktuell gemessenen Spannungswert u(n) die Differenz DU(n) ermittelt. Als Basis für die Berechnung dient die erste Anzahl j, die beispielsweise eine feste Zahl sein kann. Beispielsweise wird eine feste Zahl j an Abtastwerten für jede Berechnung verwendet. Beispielsweise kann j im Bereich 10 bis 100 liegen, insbesondere im Bereich 40-50.

Für den Fall j=40 soll die Berechnung dargestellt werden. Verwendet wird hierzu der aktuell gemessene Spannungswert u(n) und die davorliegenden respektive zurückliegenden bzw. vergangenen 39 Spannungswerte

u(n-1) bis u(n-(40-1)), d.h.

u(n-1) bis u(n-40+1), d.h.

u(n-1) bis u(39).

In Summe (j=)40 Spannungswerte.

Für die erste Teilsumme (TS1) werden die Spannungswerte u(k) für

$$k \;=\; n-(j-1) \;=\; n-(40-1) \;=\; n-39$$

bis

$$k \;=\; n-j/2 \;=\; n-40/2 \;=\; n-20$$

aufsummiert, also vom zurückliegenden (älteren) 39sten Spannungswert bis zum zurückliegenden (jüngeren) 20sten Spannungswert, in Summe 20 Werte.

Als zweite Teilsumme (TS2) werden die Spannungswerte u(k) für

$$k \;=\; n-(j/2-1) \;=\; n-(40/2-1) \;=\; n-19$$

bis

$$k = n$$

aufsummiert, also vom zurückliegenden 19ten Spannungswert bis zum aktuellen Spannungswert u(n), in Summe ebenfalls 20 Spannungswerte.

Die Differenz DU beider Teilsummen wird mit einem, von der Anzahl j abhängigen, ersten Schwellwert SW1 betragsmäßig verglichen. Bei dessen Überschreitung wird ein erstes Störlichtbogenerkennungssignal abgegeben.

Hierbei werden jeweils die Hälften der ersten Anzahl j aufsummiert. Mit Hälfte im Sinne der Erfindung ist auch ein um einen Wert abweichender halber Wert gemeint. D.h. Es könnten gemäß einer ersten Variante in der ersten Teilsumme 19 Werte und in der zweiten Teilsumme 21 Werte aufsummiert werden, wobei j den Wert 40 hat.

In einer zweiten Variante ist bei einer ungeraden ersten Anzahl j eine unsymmetrische Aufteilung gemeint. D.h. es können in einer ersten Teilsumme beispielsweise 19 Werte aufsummiert und in der zweiten Teilsumme 20 Werte aufsummiert werden, wobei j in diesem Fall den Wert 39 hätte.

Als Teilsummen können auch Mittelwerte verwendet werden, die aus den jeweiligen Spannungswerten ermittelt werden, beispielsweise durch Teilsummen. D.h. es könnte auch ein Mittelwert aus einer stark abweichenden Anzahl an Spannungswerten, beispielsweise pro Teilsumme, gebildet werden.

Alternativ können beide Teilsummen bzw. die Differenz mit einem Faktor, der beispielsweise den Kehrwert der ersten Anzahl j enthält, multipliziert werden, also beispielsweise mit 1/j oder 2/j.

$$DU(n) = \frac{2}{j}\left[\sum_{k=n-j+1}^{k=n-\frac{j}{2}} u(k) \ - \sum_{k=n-\frac{j}{2}+1}^{k=n} u(k)\right] \qquad (2)$$

Dadurch ist ein betragsmäßiger Vergleich mit einem von der Anzahl der verwendeten Abtastwerte, d.h. von der ersten Anzahl unabhängigen ersten Schwellwert SW1 möglich, da die Differenz normiert auf die im Stromkreis verwendete Spannung, d.h. dem äquivalent stattfinden Spannungssprung entspricht. Der Wert der Differenz ist somit nicht mehr von der Anzahl der Summierungen abhängig, allerdings von der verwendeten Spannung.

Man kann gemäß der ersten oder zweiten Variante die Hälfte in eine erste Teilsummenanzahl g und h aufteilen, wobei j=g+h und g≠h.

$$DU(n) = \frac{1}{g}\sum_{k=n-(g+h)+1}^{k=n-h} u(k) \ - \frac{1}{h}\sum_{k=n-h+1}^{k=n} u(k) \qquad (3)$$

Die erste Anzahl j respektive Anzahl verwendeter Abtastwerte j bestimmt über die verwendete Abtastfrequenz den verwendeten Zeitrahmen.

Umgekehrt kann bei vorgegebener Abtastfrequenz und zu überprüfenden Zeitfenster die zu verwendende erste Anzahl ermittelt werden.

Die drei Größen Zeitfenster ta, Abtastfrequenz fa und Anzahl Abtastwerte (=erste Anzahl) j sind jeweilig in einander überführbar, j = ta · fa.

Bei Netzfrequenz des Niederspannungsstromkreises von 50-60Hz hat sich eine Abtastfrequenz von 1 bis 200 kHz, insbesondere 1 bis 60 kHz, spezifischer 40 - 50 kHz, und ein Zeitfenster bzw. eine Dilatationszeit von 0,1 ms bis 5 ms oder 10 ms, insbesondere bei etwa 1 ms, für eine sichere Detektion von Störlichtbögen ergeben. Somit ergibt sich für die erste Anzahl j der benötigten Abtastwerte bzw. Abtastpunkte j = 40 - 50.

Mit Dilatationszeit ist die Ausdehnung des Zeitfensters gemeint, über den man die Teilsummen bzw. den äquivalenten Spannungssprung berechnet.

Die beiden Teilsummen TS1 und TS2 können auch vertauscht sein. D.h. die erste Teilsumme wird von der zweiten Teilsumme abgezogen. Dadurch ändert sich lediglich das Vorzeichen. Beispielsweise kann in analoger Weise bei Wechselstromnetzen nach einem Flankenwechsel, d.h. wenn von einer steigenden Flanke auf eine fallende Flanke der üblicherweise sinusförmigen Wechselspannungen gewechselt wird, ebenfalls ein Vorzeichenwechsel auftreten.

Eine steigende Flanke tritt bei sinusförmigen Spannungen üblicherweise im Bereich 0° bis 90° und 270° bis 360° auf, eine fallende Flanke üblicherweise im Bereich 90° bis 270°.

Bei betragsmäßiger Überschreitung der Differenz DU wird ein erstes Störlichtbogenerkennungssignal abgegeben.

Für die Abgabe eine zweiten Störlichtbogensignales kann eine Auswertung analog zum vorher geschriebenen gemäß Figur 3 erfolgen. In einem ersten Schritt 1 erfolgt die fortlaufende erfindungsgemäße Berechnung der Differenz DU.

In einem zweiten Schritt 2 wird diese betragsmäßig mit dem ersten Schwellwert SW1 verglichen.

Erfolgt eine Überschreitung des ersten Schwellwertes SW1, wird in einem dritten Schritt 3 ein erstes Störlichtbogenerkennungssignals abgegeben.

Ist der erste Schwellwert SW1 nicht überschritten kann in einem vierten Schritt 4 die Meldung, dass kein Störlichtbogen vorhanden ist, erfolgen.

Beispielsweise kann der erste Schwellwert SW1 im Falle einer normierten Berechnung im Bereich 8 Volt bis 300 Volt liegen, insbesondere 10 bis 30 oder 100 Volt, spezifischer im Bereich 15 bis 20 oder 25 Volt.

Wobei darauf verwiesen sei, dass die berechnete Differenz DU bzw. äquivalente Spannungssprung unter dem realen, im Spannungsverlauf erkennbaren, Spannungssprung liegt.

Eine weitere Verbesserung lässt sich durch eine weitere Aufsummierung der Differenzen DU zu einer Differenzsumme DS erreichen. Dies wird im Folgenden auch als W-RUs Verfahren bezeichnet. Bei Störlichtbögen, die keinen großen Spannungssprung erzeugen, kann so eine schnellere Detektion erreicht werden.

Bei dem W-RUs-Verfahren werden einzelne Differenzen bzw. Spannungssprünge, die besonders bei der Lichtbogenzündung in Folge von mehreren kleinen, nacheinander zündenden Lichtbögen auftreten, addiert.

Die ermittelten Differenzen DU werden mit einer zweiten Anzahl z, die im Bereich der ersten Anzahl j liegen aber auch größer oder kleiner sein kann, zu einer Differenzensumme DS aufsummiert. Beispielsweise kann die zweite Anzahl z den einbis vier- bis sechsfachen Wert von j aufweisen.

$$\mathrm{DS(n)} \;=\; \sum_{k=n-z}^{k=n} DU\,(k) \tag{4}$$

z        zweite Anzahl, d.h. Anzahl an Differenzen DU, die für die Berechnung der Differenzensumme verwendet werden

DS(n)      Differenzensumme, bezogen auf den aktuellen Wert n

Die zweite Anzahl z kann hierbei wieder über die Abtastfrequenz fa und das für die Summation zu betrachtende Zeitfenster ts bestimmt werden, z = ts · fa.

Es hat sich gezeigt, dass bei Verwendung der Summation das erste Zeitfenster bzw. die erste Dilatationszeit ta zur Berechnung des einzelnen Spannungssprungs kleiner gewählt werden kann bzw. sollte. Die Zeit ta könnte hierbei etwa 0,05 bis 1 ms betragen, insbesondere bei 0,2 ms liegen.

Ferner hat sich als vorteilhaft herausgestellt, wenn die für die Summation verwendeten Differenzen nicht ein zweites Mal, für die darauffolgende Summation verwendet werden.

Für eine einfache, programmmäßige Umsetzung des Algorithmus, kann beispielsweise für jeden Spannungswert u(n) bzw. Abtastpunkt ein relativer, äquivalenter Spannungssprung bzw. Abtastdifferenz DA(n) pro Spannungswert u(n) bezogen auf die erste Anzahl j bzw. Größe des Dilatationsparameters wie folgt berechnet werden:

$$\mathrm{DA(n)} \;=\; \frac{\mathrm{DU(n)}}{j} \tag{5}$$

D.h. die Differenz DU wird durch die erste Anzahl j geteilt, um die Abtastdifferenz für einen Spannungswert u(n) zu erhalten. Die berechnete Abtastdifferenz DA(n) beschreibt den relativen, äquivalenten Spannungssprung pro Spannungswert u(n) bzw. Abtastwert.

Beispielsweise wird ein erster Spannungswert u(1) von 36 Volt, ein nachfolgender zweiter Spannungswert u(2) von 40 Volt, ein nachfolgender dritter Spannungswert u(3) von 50 Volt, ein nachfolgender vierter Spannungswert u(4) von 60 Volt, ein nachfolgender fünfter Spannungswert u(5) von 70 Volt, ein nachfolgender sechster Spannungswert u(6) von 72 Volt, ein nachfolgender siebter Spannungswert u(7) von 74 Volt gemessen.

Beispielsweise hat die erste Anzahl j einen Wert von 4.

Gemäß Formel 2 beträgt die erste Teilsumme 76 Volt, die zweite Teilsumme 110 Volt. Die reine Differenz der Teilsummen beträgt 34 Volt, multipliziert mit 2/j, d.h. 2/4, beträgt die Differenz DU(4) 17 Volt. D.h. die Differenz entspricht einem gemittelten Spannungssprung über die 4 Spannungswerte von 17 Volt.

Bezogen auf die ersten vier Spannungswerte u(1), ..., u(4) bzw. Abtastwerte beträgt die Abtastdifferenz DA(4): 17 Volt durch 4 gleich 4,25 Volt (d.h. der relative Spannungssprung pro Spannungswert).

Bezogen auf die nächsten vier Spannungswerte u(2),..., u (5) beträgt die Differenz der Teilsummen 130 Volt - 90 Volt = 40 Volt. Die Differenz DU(5) dann wieder 20 Volt. Die Abtastdifferenz DA(5) 5 Volt (d.h. der relative Spannungssprung pro Spannungswert).

Bezogen auf die nächsten vier Spannungswerte u(3),..., u (6) beträgt die Differenz der Teilsummen 142 Volt - 110 Volt = 32 Volt, die Differenz DU(6) dann 16 Volt, die Abtastdifferenz DA(6) 4 Volt (d.h. der relative Spannungssprung pro Spannungswert) .

Bezogen auf die nächsten vier Spannungswerte u(4),..., u (7) beträgt die Differenz der Teilsummen 146 Volt - 130 Volt = 16 Volt, die Differenz DU(7) dann 8 Volt, die Abtastdifferenz DA(7) 2 Volt (d.h. der relative Spannungssprung pro Spannungswert).

In einer Ausgestaltung der Erfindung soll nun für jede (fortlaufend) berechnete Abtastdifferenz DA(n) der jeweils maximale Wert aufsummiert werden.

Dazu wird die Abtastdifferenz DA(n) jeweils den j Spannungswerten, die für die Berechnung der Differenz und Abtastdifferenz verwendet wurden, zugeordnet, siehe die nachfolgende Tabelle.

| n | U(n) | DA(1) | DA(2) | DA(3) | DA(4) | DA(5) | DA(6) | DA(7) | DAmax(n) |
|---|------|-------|-------|-------|-------|-------|-------|-------|----------|
| 1 | 36 V | 4,5V (0 V) | 9,5V (0 V) | 6,75V (0 V) | 4,25V | | | | 4,25 V |
| 2 | 40 V | | 9,5 V (0 V) | 6,75V (0 V) | 4,25V | 5 V | | | 5 V |
| 3 | 50 V | | | 6,75V (0 V) | 4,25V | 5 V | 4 V | | 5 V |
| 4 | 60 V | | | | 4,25V | 5 V | 4 V | 2 V [0 V] | 5 V |
| 5 | 70 V | | | | | 5 V | 4 V | 2 V [0 V] | 5 V |
| 6 | 72 V | | | | | | 4 V | 2 V [0 V] | 4 V |
| 7 | 74 V | | | | | | | 2 V [0 V] | 2 V [0 V] |

Falls noch nicht die erste Anzahl j Spannungswerte u(n), u(k) für eine Berechnung vorliegen, können die Differenzen bzw. Abtastdifferenzen auf Null gesetzt werden, siehe die in Klammern angegeben Werte von 0 Volt in den Spalten DA(1), DA2, DA(3).

Aus den j zugeordneten Abtastdifferenzen pro Spannungswert U(n) wird jeweils die maximale Abtastdifferenz DAmax(n) ermittelt. Dabei liegen natürlich für die gerade zurückliegenden Abtastdifferenzen DA(n) nur weniger als j Abtastdifferenzen DA vor, wobei dann die aktuelle bzw. maximale Abtastdifferenz DA der vorliegenden Abtastdifferenzen verwendet wird.

Die maximalen Abtastdifferenzen DAmax pro Spannungswert U(n) werden zu einer Summe der maximalen Abtastdifferenzen SMA aufsummiert, und zwar jeweils eine zweite Anzahl z an maximalen Abtastdifferenzen SMA.

$$\text{SMA(n)} \quad = \quad \sum_{k=n-z}^{k=n} DAmax(k) \qquad\qquad (6)$$

Hat die zweite Anzahl z beispielsweise einen Wert von z=6, ergibt sich ein Summe der maximalen Abtastdifferenzen für die ersten 6 maximalen Abtastdifferenzen von SMA(6) = 28,25 Volt.

Die Summe der maximalen Abtastdifferenzen SMA bzw. dessen Betrag wird mit dem ersten Schwellwert SW1 verglichen und bei dessen betragsmäßiger Überschreitung ein erstes Störlichtbogenerkennungssignal SLES abgegeben.

Dies hat den Vorteil, dass mehrere in Folge auftretende Spannungssprünge aufsummiert werden und deren Summe für die Auswertung des Vorliegens eines Störlichtbogens verwendet werden.

In einer Ausgestaltung der Erfindung kann ein weiterer Schwellwertvergleich dahingehend vorgesehen sein, dass für die Berechnung der Abtastdifferenz DA(n) der Wert von DU(n) auf Null gesetzt wird, wenn dessen Betrag einen fünften Schwellwert SW5 unterschreitet.

Für ein Niederspannungsnetz kann dieser fünfte Schwellwert SW5 im Bereich im Bereich 8 Volt bis 50 Volt liegen, insbesondere 10 bis 30, spezifischer im Bereich 10 bis 20 oder 25 Volt liegen.

Er kann auch identisch mit dem Betrag des ersten Schwellwertes sein bzw. in dessen Größenordnung liegen.

Dies hat den Vorteil, dass der typische - üblicherweise sinusförmige - Spannungsverlauf nicht bzw. weniger berücksichtigt wird.

Beispielsweise könnte gemäß Beispiel die siebte Differenz DU(7), die den Wert 8 Volt aufweist, betragsmäßig unter dem fünften Schwellwert SW5 liegen, der beispielsweise einen Betrag von 10 Volt aufweist. Damit würde die siebte Abtastdifferenz DA(7) den Wert 0 Volt aufweisen. Dies insbesondere in Spalte DA(7) durch Werte von 0 Volt in eckigen Klammern dargestellt.

Figur 2 zeigt ein Ersatzschaltbild eines elektrischen Stromkreises, aufweisend ein elektrische Energiequelle 100, die eine elektrische Netz-Spannung $u_n(t)$ zur Verfügung stellt, ein daran angeschlossenen Netzzugang bzw. ein Einspeise-Kabel 200, dargestellt durch elektrische Ersatzschaltelemente, wie einen Einspeise-Kabel-Widerstand $R_{ek}$ und eine Einspeise-Kabel-Induktivität bzw. Spule $L_{ek}$, dem ein elektrischer Verbraucher, Betriebsmittel bzw. Energiesenke 300 folgt, wiederum dargestellt durch elektrische Ersatzschaltelemente, wie einen Verbraucher-Widerstand $R_{BM}$ und eine Verbraucher-Induktivität bzw. Spule $L_{BM}$. Zwischen Einspeise-Kabel 200 und Verbraucher 300 kann eine elektrische Spannung $u_m$ (t) und eine elektrische Stromgröße, wie der elektrische Stromwert $i_m$ (t) oder/und die Änderung des Stromes nach der Zeit $i'_m$ (t), respektive die erste Ableitung des Stromes nach der Zeit, gemessen werden.

Diese Größen, insbesondere die elektrische Spannung bzw. elektrischen Spannungswerte, werden an den Meßpunkten 600 erfasst, um in der Störlichtbogenerkennungseinheit weiter verarbeitet zu werden.

Der hinsichtlich Störlichtbogen überwachte Bereich ist durch eine gestrichelte Linie 500 dargestellt.

Im elektrischen Stromkreis kann ein Störlichtbogen auftreten, der durch einen Lichtbogen 400 mit einer Lichtbogenspannung $U_{lb}$(t) dargestellt ist. Erfindungsgemäß wird für die zweite Störlichtbogenerkennungsfunktion fortlaufend eine Lichtbogenspannung $U_{lb}$ in der Störlichtbogenerkennungseinheit mit Hilfe der gemessenen/abgetasteten Spannung $u_m$ (t) und der gemessenen/abgetasteten Stromgröße (Strom oder/und Stromänderung) berechnet.

Erfindungsgemäß wird für die Berechnung die Spannung, der Strom und die Änderung des Stromes nach der Zeit verwendet. Hierzu wird ein solches Wertepaar mindestens einem Wertesatz zugeordnet. In einer bevorzugten Ausführungsform wird ein Wertepaar genau einem Wertesatz zugeordnet. Wesentlich ist, dass ein Wertesatz mindestens ein Wertepaar enthält, das nicht im vorhergehenden oder nachfolgenden Wertesatz enthalten ist.

Erfindungsgemäß wird aus mindestens zwei Wertesätzen eine Lichtbogenspannung berechnet.

In einer bevorzugten Ausgestaltung wird eine feste Anzahl Wertepaare, die beispielsweise zeitlich nacheinander, beispielsweise mit festem zeitlichem Abstand, ermittelt werden, einem Wertesatz zugeordnet. Beispielsweise enthält ein Wertesatz 10 Wertepaare. Die ersten 10 Wertepaare werden dem ersten Wertesatz zugeordnet. Die zweiten 10 Wertepaare werden dem zweiten Wertesatz zugeordnet, die dritten 10 Wertepaare dem dritten Wertesatz usw.

Jeweils mindestens 2 Wertesätze werden für die Ermittlung einer Lichtbogenspannung bzw. eines Störlichtbogens verwendet. Die Berechnung erfolgt fortlaufend, d.h. beispielsweise erste Berechnung mit den Wertesätzen 1 und 2 bzw. 1 bis 3, zweite erfindungsgemäße Berechnung mit den Wertesätzen 2 und 3 bzw. 2 bis 4, usw. (erste Angabe für Berechnung mit 2 Wertesätzen, zweite Angabe für Berechnung mit 3 Wertesätzen).

1.Beispiel:

Beispielsweise werden Wertepaare von 1 bis x ($x \geq 32$; $x \in \mathbb{N}$) abgetastet und ein Wertesatz besteht aus 10 Wertepaaren. Jeweils 3 Wertesätze werden für die Ermittlung einer Lichtbogenspannung bzw. eines Störlichtbogens verwendet.

Die Wertepaare 1 - 10 werden dem Wertesatz 1 zugeordnet.

Die Wertepaare 11 - 20 werden dem Wertesatz 2 zugeordnet.

Die Wertepaare 21 - 30 werden dem Wertesatz 3 zugeordnet.

Die Berechnung erfolgt fortlaufend, d.h. beispielsweise erste erfindungsgemäße Berechnung mit den Wertepaaren 1 bis 30, zweite erfindungsgemäße Berechnung mit den Wertepaaren 2 bis 31, dritte erfindungsgemäße Berechnung mit den Wertepaaren 3 bis 32, usw. Somit steht zu jedem Abtastpunkt ein Berechnungsergebnis für die anschließende Auswertung zur Verfügung.

2.Beispiel:

Für die Berechnung können sich auch Wertesätze überlagern. D.h. zwei Wertesätze können ein oder mehrere gleiche Wertepaare verwenden. Wobei hier der Grundsatz gilt, dass in jedem Wertesatz mindestens ein weiteres Wertepaar vorhanden sein muss, dass in den anderen Wertessätzen nicht verwendet wird. Beispielsweise es werden Wertepaare von 1 bis x ($x \geq 14$; $x \in \mathbb{N}$) abgetastet und ein Wertesatz besteht aus 10 Wertepaaren. Jeweils 3 Wertesätze werden für die Ermittlung einer Lichtbogenspannung bzw. eines Störlichtbogens verwendet.

Die Wertepaare 1 - 10 werden dem Wertesatz 1 zugeordnet.

Die Wertepaare 2 - 11 werden dem Wertesatz 2 zugeordnet.

Die Wertepaare 3 - 12 werden dem Wertesatz 3 zugeordnet.

Die Berechnung erfolgt fortlaufend, d.h. beispielsweise erste erfindungsgemäße Berechnung mit den Wertepaaren 1 bis 12, zweite erfindungsgemäße Berechnung mit den Wertepaaren 2 bis 13, dritte erfindungsgemäße Berechnung mit den Wertepaaren 3 bis 14, usw. Somit steht zu jedem Abtastpunkt ein Berechnungsergebnis für die anschließende Auswertung zur Verfügung.

3.Beispiel:

Für die Berechnung können die Wertesätze auch eine unterschiedliche Größe besitzen. Beispielsweise werden Wertepaare von 1 bis x (x ≥ 17; $x \in \mathbb{N}$ ) abgetastet. Jeweils 3 Wertesätze werden für die Ermittlung einer Lichtbogenspannung bzw. eines Störlichtbogens verwendet, wobei der 1. Wertesatz aus 6 Wertepaaren besteht, der 2. Wertesatz aus 15 Wertepaaren besteht und der 3. Wertesatz aus 9 Wertepaaren besteht.

Die Wertepaare 1 - 6 werden dem Wertesatz 1 zugeordnet.

Die Wertepaare 1 - 15 werden dem Wertesatz 2 zugeordnet.

Die Wertepaare 6 - 15 werden dem Wertesatz 3 zugeordnet.

Die Berechnung erfolgt fortlaufend, d.h. beispielsweise erste erfindungsgemäße Berechnung mit den Wertepaaren 1 bis 15; darin sind die drei Wertesätze enthalten. Die zweite erfindungsgemäße Berechnung mit den Wertepaaren 2 bis 16 und dritte erfindungsgemäße Berechnung mit den Wertepaaren 3 bis 17, usw. Somit steht zu jedem Abtastpunkt ein Berechnungsergebnis für die anschließende Auswertung zur Verfügung.

Im Weiteren können beispielsweise die Wertepaare auch nacheinander angeordnet sein und einen Abstand von einer bestimmten Anzahl von Wertepaaren zueinander haben.

Die Berechnung erfolgt dadurch, dass fortlaufend gewisse Terme (mathematische Ausdrücke bzw. Gleichungen) berechnet werden.

Die Berechnung dieser Terme basiert auf einer Lösung der Leitungsgleichung 1.Ordnung:

$$u_m(t) = R_{BM} \cdot i_m(t) + L_{BM} \frac{di_m(t)}{dt} \qquad (1)$$

Unter der Annahme, dass im Niederspannungsnetz ein Störlichtbogen vorhanden ist, so wäre das elektrische Verhalten vergleichbar mit dem einer Gegenspannungsquelle im Netz.

Daraus ergibt sich die folgende, erweiterte Ansatzdifferenzialgleichung:

$$u_m(t) = R_{BM} \cdot i_m(t) + L_{BM} \frac{di_m(t)}{dt} + u_{LB}(t) \qquad (2)$$

Der Störlichtbogen wird vereinfacht als rein ohmscher Verbraucher nachgebildet. Somit wird angenommen, dass die Lichtbogenspannung phasengleich zum Lichtbogenstrom ist. Die Lichtbogenspannung kann somit mit folgender Gleichung beschrieben werden:

$$u_{LB}(t) = U_{LB} \cdot \text{sign}\big(i_{LB}(t)\big) \qquad (3)$$

Wird davon ausgegangen, dass der Messstrom $i_m(t)$ dem Stör-lichtbogenstrom $i_{LB}(t)$ entspricht, also keine Stromverzweigung zwischen Messort und Störlichtbogenbrennstelle vorhanden ist, kann geschrieben werden:

$$u_m(t) = R_{BM} \cdot i_m(t) + L_{BM} \frac{di_m(t)}{dt} + \text{sign}\big(i_m(t)\big) \cdot U_{LB} \qquad (4)$$

Zum Lösen dieser erweiterten Ansatzdifferenzialgleichung wird erfindungsgemäß ein integrierendes Lösungsverfahren verwendet. Somit ergibt sich ein vollständiger, integrierender Ansatz :

$$\int u_m(t)\, dt = R_{BM} \int i_m(t)\, dt + L_{BM} \int \frac{di_m(t)}{dt}\, dt + U_{LB} \int \text{sign}\big(i_m(t)\big)\, dt \qquad (5)$$

Die Berechnung der Lichtbogenspannung erfolgt durch Umstellen und Auflösen der Gleichung (5) nach $U_{LB}$.

Für die Berechnung wird die folgende Ansatzgleichung verwendet :

$$\begin{aligned} \int u_m(t)\, dt &= R_{BM} \int i_m(t)\, dt + L_{BM} \int \frac{di_m(t)}{dt}\, dt + U_{LB} \int \text{sign}\big(i_m(t)\big)\, dt \\ &= R_{BM} \int i_m(t)\, dt + L_{BM} \int i'_m(t)\, dt + U_{LB} \int \text{sign}\big(i_m(t)\big)\, dt \end{aligned} \qquad (6)$$

Für die nummerische Integration wird beispielsweise das Sehnentrapezverfahren nach Gleichung (7) verwendet.

$$\int_{t_A}^{t_E} f(t)dt \approx \frac{\Delta t}{2}\left[f(t_A) + 2 \sum_{\nu=1}^{\frac{t_E - t_A}{\Delta t} - 1} f(t_A + \nu \cdot \Delta t) + f(t_E)\right] \tag{7}$$

Für eine vereinfachte Darstellung der Lösung werden die mit der Sehnentrapezregel gelösten Integrationsintervalle durch folgende Terme substituiert:

$$u_s = \frac{\Delta t}{2}\left[u_m(t_A) + 2 \sum_{\nu=1}^{\frac{t_E - t_A}{\Delta t} - 1} u_m(t_A + \nu \cdot \Delta t) + u_m(t_E)\right] \tag{8}$$

$$i_s = \frac{\Delta t}{2}\left[i_m(t_A) + 2 \sum_{\nu=1}^{\frac{t_E - t_A}{\Delta t} - 1} i_m(t_A + \nu \cdot \Delta t) + i_m(t_E)\right] \tag{9}$$

$$i'_s = \frac{\Delta t}{2}\left[i'_m(t_A) + 2 \sum_{\nu=1}^{\frac{t_E - t_A}{\Delta t} - 1} i'_m(t_A + \nu \cdot \Delta t) + i'_m(t_E)\right] \tag{10}$$

$$s_s = \frac{\Delta t}{2}\left[\text{sign}(i_m(t_A)) + 2 \sum_{\nu=1}^{\frac{t_E - t_A}{\Delta t} - 1} \text{sign}(i_m(t_A + \nu \cdot \Delta t)) + \text{sign}(i_m(t_E))\right] \tag{11}$$

$$t_s = \frac{t_E - t_A}{\Delta t}$$

Der Wert $t_s$ ist dabei die Anzahl der Wertepaare pro Wertesatz, $\Delta t$ entspricht dem Bezugszeichen dt, welches dem zeitlichen Abstand der abgetasteten Spannungswerte bzw. Stromgrößen respektive Wertepaare entspricht.
Die Variable $t_E$ entspricht der Zeit vom zeitlich letzten Wertepaar eines Wertesatzes, $t_A$ entspricht der Zeit vom zeitlich ersten Wertepaar des Wertesatzes.
Mit den Formel 8 bis 11 werden für einen Wertesatz jeweils die folgenden Terme berechnet:

(8) ein Zeit-Spannungssummen-Produkt ($u_s$), gebildet aus dem Zeitabstand (dt) und der Summe der Spannungswerte ($u_m$), wobei die Summe der Spannungswerte durch den halben ersten Spannungswert, den halben letzten Spannungswert und der Summe der übrigen Spannungswerte des Wertesatzes gebildet wird.

(9) ein Zeit-Stromsummen-Produkt ($i_s$), gebildet aus dem Zeitabstand (dt) und der Summe der Stromwerte, wobei die Summe des Stromwerte durch den halben ersten Stromwert, den halben letzten Stromwert und der Summe des übrigen Stromwerte des Wertesatzes gebildet wird.

(10) ein Zeit-Stromänderungswert-Produkt ($i'_s$), gebildet aus dem Zeitabstand (dt) und der Summe der Werte für die Änderung des Stromes nach der Zeit, wobei die Summe der Werte für die Änderung des Stromes nach der Zeit durch den halben ersten Wert, den halben letzten Wert und der Summe der übrigen Werte des Wertesatzes gebildet wird.

(11) ein Zeit-Vorzeichenwert-Produkt ($s_s$), gebildet aus dem Zeitabstand (dt) und der Summe der Vorzeichenwerte der Stromwerte, wobei ein Vorzeichenwert den Wert plus Eins bei positiven Stromwert, minus Eins bei negativen Stromwert und Null bei einem Stromwert von Null annimmt, wobei die Summe der Vorzeichenwerte aus dem halben Vorzeichenwert des ersten Stromwertes, dem halben Vorzeichenwert des letzten Stromwertes und der Summe der Vorzeichenwerte der übrigen Stromwerte gebildet wird.

Mit den substituierten Termen ergibt sich das Gleichungssystem entsprechend der Ansatzgleichung 5 zu:

$$u_s = R_{BM}i_s + L_{BM}i'_s + U_{LB}s_s \qquad (13)$$

Das Gleichungssystem enthält die drei unbekannten len $R_{BM}$, $L_{BM}$ und $U_{LB}$. Für die Lösung dessen werden (mindestens) zwei, für eine sehr genaue Ermittlung drei, voneinander zeitlich unterschiedliche Integrationsgrenzen verwendet, beispielsweise durch erfindungsgemäße Verwendung zweier bzw. dreier Wertesätze.

$$u_{s1} = R_{BM}i_{s1} + L_{BM}i'_{s1} + U_{LB}s_{s1}$$
$$u_{s2} = R_{BM}i_{s2} + L_{BM}i'_{s2} + U_{LB}s_{s2} \qquad (14)$$
$$u_{s3} = R_{BM}i_{s3} + L_{BM}i'_{s3} + U_{LB}s_{s3}$$

Die Lichtbogenspannung $U_{LB}$ lässt sich folglich erfindungsgemäß beispielsweise mit der folgenden Formel berechnen.

$$U_{LB} = \frac{(u_{s3}i_{s2} - u_{s2}i_{s3})(i'_{s2}i_{s1} - i'_{s1}i_{s2}) - (u_{s2}i_{s1} - u_{s1}i_{s2})(i'_{s3}i_{s2} - i'_{s2}i_{s3})}{(s_{s1}i_{s2} - s_{s2}i_{s1})(i'_{s3}i_{s2} - i'_{s2}i_{s3}) - (s_{s2}i_{s3} - s_{s3}i_{s2})(i'_{s2}i_{s1} - i'_{s1}i_{s2})} \qquad (15)$$

Wobei $u_s$, $i_s$, $i'_s$, $s_s$ die Zeit-Spannungssummen-Produkte, Zeit-Stromsummen-Produkte, Zeit-Stromänderungswert-Produkte, Zeit-Vorzeichenwert-Produkte, gemäß Formel 8 bis 11, eines ersten, zweiten und dritten Wertesatzes sind, gemäß Index.

Das Kürzel sign bzw. sgn steht für die Signumfunktion respektive Vorzeichenfunktion. Diese Funktion ordnet einer Zahl ihr Vorzeichen zu. Diese ist wie folgt definiert:

```
sign(x) = +1, falls x>0;

sign(x) = 0, falls x=0;

sign(x) = -1, falls x<0.
```

Die Formel 14 besteht aus 12 Produkten P1,...,P12, die enthalten:

a) Produkte aus Zeit-Spannungssummen-Produkten $u_s$ und Zeit-Stromsummen-Produkten $i_s$,
b) Produkte aus Zeit-Stromdummen-Produkten $i_s$ und Zeit-Stromänderungswert-Produkten $i'_s$,
c) Produkte aus Zeit-Vorzeichenwert-Produkten $s_s$ und Zeit-Stromsummen-Produkte $i_s$.

$$U_{LB} = \frac{(P1 - P2)(P3 - P4) - (P5 - P6)(P7 - P8)}{(P9 - P10)(P7 - P8) - (P11 - P12)(P3 - P4)} \qquad (15)$$

$$U_{LB} = \frac{D1 * D2 - D3 * D4}{D5 * D4 - D6 * D2} \qquad (16)$$

$$U_{LB} = \frac{P13 - P14}{P15 - P16} \qquad (17)$$

$$U_{\mathrm{LB}} = \frac{D7}{D8} \qquad\qquad (18)$$

Die 12 Produkte bilden 6 verschiedene Differenzen D1, ..., D6.

Die 6 Differenzen D1, ..., D6 bilden wiederum 4 übergeordnete Produkte P13, ..., P16. Diese bilden wiederum 2 übergeordnete Differenzen D7, D8, mit Hilfe denen eine Lichtbogenspannung ermittelt werden kann. Überschreitet diese betragsmäßig den zweiten Schwellwert SW2, wird das zweite Störlichtbogenerkennungssignal abgegeben.

Die Lichtbogenspannung lässt sich ferner beispielsweise mit den folgenden, vereinfachten Formeln, die ebenfalls Lösungen der Integralgleichung sind, berechnen. Hierbei werden erfindungsgemäß nur zwei Wertesätze für die Ermittlung benötigt.

$$U_{\mathrm{LB}} = \frac{u_{s2}i_{s1} - u_{s1}i_{s2}}{t_{s2}i_{s1} - t_{s1}i_{s2}} = \frac{P5 - P6}{P17 - P18} = \frac{D3}{D9}$$

$$U_{\mathrm{LB}} = \frac{u_{s2}i_{s1} - u_{s1}i_{s2}}{s_{s2}i_{s1} - s_{s1}i_{s2}} = \frac{P5 - P6}{P10 - P9} = \frac{D3}{D10}$$

$$U_{\mathrm{LB}} = \frac{u_{s2}i'_{s1} - u_{s1}i'_{s2}}{t_{s2}i'_{s1} - t_{s1}i'_{s2}} = \frac{P19 - P20}{P21 - P22} = \frac{D11}{D12}$$

$$U_{\mathrm{LB}} = \frac{u_{s2}i'_{s1} - u_{s1}i'_{s2}}{s_{s2}i'_{s1} - s_{s1}i'_{s2}} = \frac{P19 - P20}{P23 - P24} = \frac{D11}{D13}$$

Eine weitere beispielhafte Berechnung unter Verwendung dreier Wertesätze ist in der nachfolgenden Formel gegeben.

$$U_{\mathrm{LB}} = \frac{(u_{s2}i_{s1} - u_{s1}i_{s2})(i'_{s3}i_{s1} - i'_{s1}i_{s3}) - (u_{s3}i_{s1} - u_{s1}i_{s3})(i'_{s2}i_{s1} - i'_{s1}i_{s2})}{(t_{s1}i_{s3} - t_{s3}i_{s1})(i'_{s2}i_{s1} - i'_{s1}i_{s2}) - (t_{s1}i_{s2} - t_{s2}i_{s1})(i'_{s3}i_{s1} - i'_{s1}i_{s3})}$$

$$U_{\mathrm{LB}} = \frac{(P5 - P6)(P25 - P26) - (P27 - P28)(P3 - P4)}{(P29 - P30)(P3 - P4) - (P18 - P17)(P25 - P26)}$$

$$U_{\mathrm{LB}} = \frac{D3\,D14 - D15\,D2}{D16\,D2 - D17\,D14}$$

$$U_{\mathrm{LB}} = \frac{P31 - P32}{P33 - P34}$$

$$U_{\mathrm{LB}} = \frac{D18}{D19}$$

Jede Lösung der Integralgleichung, auch eine vereinfachte, stellt eine erfindungsgemäße Verwendung der Erfindung dar.

An Hand von Figur 3 kann in analoger Weise eine Unterscheidung getroffen werden.

Beispielsweise kann der zweite Schwellwert SW2 bzw. dessen Betrag für diesen Fall bei 30 Volt liegen.

Allgemein gesagt kann der Schwellwert für ein Niederspannungsnetz im Bereich 20 bis 300 Volt liegen, konkreter im Bereich 20 bis 150 Volt, spezifischer im Bereich 20 bis 70 Volt. Insbesondere Werte von 25 bis 50 Volt scheinen gut geeignet zu sein.

Bei der Berechnung der Lichtbogenspannung mit der erfindungsgemäßen Auswertung können bei der Zündung eines Lichtbogens starke Änderungen auftreten. Für eine schnelle und stabile Berechnung der Lichtbogenspannung können deshalb noch Verbesserungen derart erfolgen, dass beispielsweise die Vorzeichen- bzw. Signumfunktion modifiziert wird.

Im Allgemeinen berechnet sich die Signumfunktion aus dem gemessenen Strom wie folgt:

$$s(t) = \text{sign}\big(i_m(t)\big)$$

Stabile Berechnungsergebnisse liegen häufig erst für die Zeit nach der Lichtbogenzündung vor, wenn die Messspannung den brennenden Lichtbogen komplett erfasst hat und in den zwei bzw. drei Integrationsintervalle bzw. Wertesätze komplett enthalten ist. Im Übergangsbereich kann es zu instabilen Berechnungsergebnissen kommen. Werden für diesen Bereich die Berechnungsergebnisse gefiltert, so erfolgt dadurch eine geringfügige Verzögerung der Detektion, allerdings mit sichereren Ermittlungsergebnissen. Erfindungsgemäß kann daher eine weitere Ausgestaltung verwendet werden, bei der die Signumfunktion auf den Wert Null gesetzt wird, wenn die ermittelte Spannung einen sechsten Schwellwert SW6, wie z.B. einen Spannungsschwellwert, unterschreitet.

$$s(t) = 0 \mid |u_m(t)| \leq U_{I-RLs}^s$$

Das Ergebnis der Signumfunktion wird z.B. immer Null gesetzt, wenn der Betrag des, beispielsweise zeitgleichen, Spannungswerts des Wertepaares kleiner-gleich dem sechsten Schwellwert SW6, wie $U_{I-RLs}^s$, ist. Als typischer Schwellwert kann hierfür z.B. der Anoden-Kathodenspannungsabfall von etwa 20 V angenommen werden, da davon auszugehen ist, dass unter diesem Wert kein Lichtbogen entstehen kann. Der sechste Schwellwert SW6 bzw. $U_{I-RLs}^s$ kann jeden Wert im Bereich 5 bis 150 Volt, spezifischer im Bereich 10 Volt bis 50 Volt, insbesondere 15 bis 20 Volt annehmen.

Durch Einführung dieser Nebenbedingung für die Berechnung der Signumfunktion werden bei der Lichtbogenzündung eventuell auftretende Instabilitäten in der Berechnung der Lichtbogenspannung minimiert.

Um weiterhin unzulässige Berechnungsergebnisse zu vermeiden, kann erfindungsgemäß vorteilhaft die Lichtbogenspannung auf den Wert Null gesetzt werden, wenn die Summe der zwei bzw. drei Integrale $s_s$ der Signumfunktion bzw. die Summe der zwei bzw. drei Zeit-Vorzeichenwert-Produkte $s_s$ den Wert Null ergibt.

$$U_{LB} = 0\,\text{V} \mid s_{s1} + s_{s2} = 0$$

$$U_{LB} = 0\,\text{V} \mid s_{s1} + s_{s2} + s_{s3} = 0$$

Die zweite Störlichtbogenfunktion kann alternativ auch durch Wertepaare, beispielsweise durch einen differentiellen Ansatz, erfolgen. Erfindungsgemäß wird für die Berechnung auch hier die Spannung, der Strom und die Änderung des Stromes nach der Zeit verwendet.

Erfindungsgemäß müssen mindestens zwei Wertepaare dieser Grö-βen vorliegen.

Die Berechnung erfolgt dadurch, dass fortlaufend gewisse Terme (mathematische Ausdrücke bzw. Gleichungen) berechnet werden.

Die Berechnung dieser Terme basiert auch hier auf einer Lösung der Leitungsgleichung 1.Ordnung unter den bereits genannten Annahmen.

$$u_m(t) = R_{BM} \cdot i_m(t) + L_{BM}\frac{di_m(t)}{dt}$$

$$u_m(t) = R_{BM} \cdot i_m(t) + L_{BM}\frac{di_m(t)}{dt} + \text{sign}\big(i_m(t)\big) \cdot U_{LB}$$

Zum Lösen dieser erweiterten Ansatzdifferenzialgleichung wird erfindungsgemäß ein differenzierendes Lösungsverfahren verwendet. Die Berechnung der Lichtbogenspannung erfolgt erfindungsgemäß durch Umstellen und Auflösen der vorstehenden Gleichung nach $U_{LB}$.

$$u_m(t) = R_{BM} \cdot i_m(t) + L_{BM} \cdot \frac{di_m(t)}{dt} + U_{LB} \cdot sgn(i_m(t))$$
$$= R_{BM} \cdot i_m(t) + L_{BM} \cdot i'_m(t) + U_{LB} \cdot sgn(i_m(t))$$

Eine Vereinfachung der Gleichung lässt sich dadurch erreichen, dass erfindungsgemäß einzelne Komponenten bzw. Elemente der Gleichung nicht berücksichtigt werden. Beispielsweise dass nur die Lichtbogenspannung und die ohmsche bzw. Widerstandskomponente berücksichtigt wird. Alternativ beispielsweise nur die induktive Komponente, induktive plus Vorzeichen des Stromes, ohmsche plus Vorzeichen des Stromes, ohmsche und induktive. In seiner vollständigen Form werden sowohl die ohmsche und induktive Komponente und das Vorzeichen des Stromes berücksichtigt.

Eine solche Vereinfachung hat den besonderen Vorteil, dass dadurch eine besonders einfache Ermittlung der Lichtbogenspannung ermöglicht wird und somit eine einfache Möglichkeit zur Ermittlung eines Störlichtbogen gegeben ist.

Bei Berücksichtigung nicht aller Komponenten lassen sich durch erfindungsgemäße Verwendung zweier unterschiedlicher Wertepaare die Lichtbogenspannung und die entsprechende Komponente berechnen.

Dabei kann beispielsweise die Lichtbogenspannung wie folgt berechnet werden.

$$U_{LB} = \frac{i_2 \cdot u_1 - i_1 \cdot u_2}{i_2 - i_1} = \frac{PD13 - PD14}{DD9} = \frac{DD10}{DD9}$$

$$U_{LB} = \frac{i_2 \cdot u_1 - i_1 \cdot u_2}{sgn(i_1) \cdot i_2 - sgn(i_2) \cdot i_1} = \frac{PD13 - PD14}{DD1} = \frac{DD10}{DD1}$$

$$U_{LB} = \frac{i'_2 \cdot u_1 - i'_1 \cdot u_2}{i'_2 - i'_1} = \frac{PD15 - PD16}{DD11} = \frac{DD12}{DD11}$$

$$U_{LB} = \frac{i'_2 \cdot u_1 - i'_1 \cdot u_2}{sgn(i_1) \cdot i'_2 - sgn(i_2) \cdot i'_1} = \frac{PD15 - PD16}{DD13} = \frac{DD12}{DD13}$$

Durch erfindungsgemäße Verwendung dreier unterschiedlicher Wertepaare lässt sich die Lichtbogenspannung $U_{LB}$ berechnen.

Die Lichtbogenspannung $U_{LB}$ lässt sich erfindungsgemäß beispielsweise wie folgt mit einer der nachfolgenden Formeln berechnen:

$$U_{LB} = \frac{(u_3 i_1 - u_1 i_3)(i'_2 i_1 - i'_1 i_2) - (u_2 i_1 - u_1 i_2)(i'_3 i_1 - i'_1 i_3)}{(i_2 - i_1)(i'_3 i_1 - i'_1 i_3) - (i_3 - i_1)(i'_2 i_1 - i'_1 i_2)}$$

$$U_{LB} = \frac{(PD1 - PD2)(PD3 - PD4) - (PD5 - PD6)(PD7 - PD8)}{(DD9)(PD7 - PD8) - (DD14)(PD3 - PD4)}$$

$$U_{LB} = \frac{DD3 * DD4 - DD5 * DD6}{DD9 * DD6 - DD14 * DD4}$$

$$U_{LB} = \frac{PD9 - PD10}{PD17 - PD18} = \frac{DD7}{DD15}$$

Oder:

$$U_{LB} = \frac{(u_3 i_1 - u_1 i_3)(i'_2 i_1 - i'_1 i_2) - (u_2 i_1 - u_1 i_2)(i'_3 i_1 - i'_1 i_3)}{(sgn(i_1)i_2 - sgn(i_2)i_1)(i'_3 i_1 - i'_1 i_3) - (sgn(i_1)i_3 - sgn(i_3)i_1)(i'_2 i_1 - i'_1 i_2)}$$

Wobei $u_1$, $i_1$, $i'_1$ die Spannungs-, Strom- und Stromänderungswerte eines ersten Wertepaares sind. Die Indizes gelten analog für das zweite bzw. dritte Wertepaar.

Das Kürzel sgn steht für die Signumfunktion respektive Vorzeichenfunktion. Diese Funktion ordnet einer Zahl ihr Vorzeichen zu. Diese ist wie folgt definiert:

sgn(x) = +1, falls x>0;
sgn(x) = 0, falls x=0;
sgn(x) = -1, falls x<0.

Die vorstehende Formel besteht aus zwei Differenzen DD1, DD2, aus mehreren Produkten PD1,...,PD8, die wiederum die Basis für Differenzen DD3 bis DD6 bilden. Diese können wiederum zu Produkten PD9,...,PD12 zusammengefasst werden. Diese Produkte bilden die Basis für zwei weitere Differenzen DD7, DD8, mit deren Hilfe die Lichtbogenspannung berechnet werden kann. Die vorstehende Formel kann wie folgt umgeschrieben werden:

$$U_{LB} = \frac{(PD1 - PD2)(PD3 - PD4) - (PD5 - PD6)(PD7 - PD8)}{(DD1)(PD7 - PD8) - (DD2)(PD3 - PD4)}$$

$$U_{LB} = \frac{DD3 * DD4 - DD5 * DD6}{DD1 * DD6 - DD2 * DD4}$$

$$U_{LB} = \frac{PD9 - PD10}{PD11 - PD12}$$

$$U_{LB} = \frac{DD7}{DD8} \tag{10}$$

Der Schwellwertvergleich kann wieder analog gemäß Figur 3 vorgenommen werden. In einem ersten Schritt 1 erfolgt die fortlaufende Berechnung der Lichtbogenspannung.

In einem zweiten Schritt 2 wird diese jeweils mit dem zweiten Schwellwert SW2 verglichen.

Erfolgt eine betragsmäßige Überschreitung des zweiten Schwellwertes SW2, wird in einem dritten Schritt 3 die ein zweites Störlichtbogenerkennungssignals abgegeben.

Ist der Schwellwert SW nicht überschritten, kann in einem vierten Schritt 4 die Meldung, dass kein Störlichtbogen vorhanden ist, erfolgen.

Beispielsweise kann der zweite Schwellwert SW2 bzw. dessen Betrag für diesen Fall bei 30 Volt liegen.

Ausgehend von etwa 10-20 V für den Anoden-Kathodenfall beruht die Annahme darauf, dass noch etwa 10 V zusätzlich für die Lichtbogensäule benötigt werden.

Allgemein gesagt kann der Schwellwert für ein, insbesondere 400 Volt, Niederspannungsnetz im Bereich 20 bis 300 Volt liegen, spezifischer im Bereich 20 bis 70 Volt. Insbesondere Werte von 25 bis 50 Volt scheinen gut geeignet zu sein.

Die Störlichtbogenerkennung kann erfindungsgemäß mit weiteren Kriterien kombiniert werden. Beispielse mit einem weiteren Vergleich der Höhe des elektrischen Stromes des Stromkreises. Der gemessene Strom, insbesondere der Effektivwert des gemessenen Stromes, der beispielsweise nach der Methode von Mann-Morrison berechnet werden kann, wird dabei mit einem dritten Schwellwert SW3 verglichen und nur wenn auch dieser dritte Schwellwert SW3 überschritten ist und das Kriterium für ein Störlichtbogenerkennungssignal erfüllt ist, wird ein solches abgegeben.

Diese als Überstromfreigabe bezeichnetes Kriterium führt zu einer sicheren Fehlerabgrenzung. Für die Störlichtbogenerkennung muss ein minimaler Störlichtbogenstrom im Stromkreis fließen, um ein Störlichtbogenerkennungssignal zu bewirken. Als Schwellwert für die Überstromfreigabe kann ein vom Betriebsstrom abhängiger Wert gewählt werden. Alternativ könnte die Schwellwertfestlegung auch lichtbogenspezifisch erfolgen, da für einen brennenden parallelen Niederspannungslichtbogen ein Lichtbogenstrom von üblicherweise 1000 A notwendig ist. Ein serieller Lichtbogen ist bei wesentlich geringeren Strömen möglich. D.h. der dritte Schwellwert SW3 kann je nach Einsatz bzw. Anwendung jeden Wert ab 1 A, 10 A, 100 A, 1000 A oder 5000 A aufweisen.

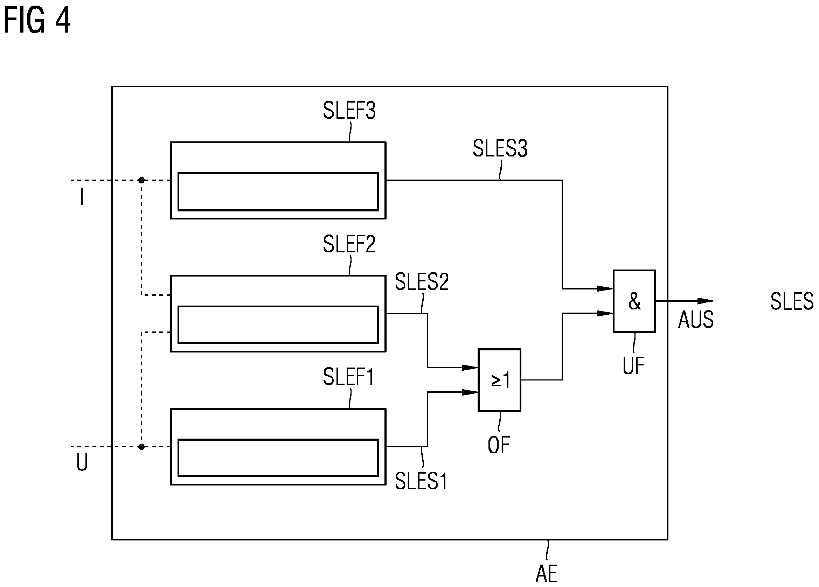

Die Verknüpfung zwischen Überstromfreigabe und der erfindungsgemäßen Lichtbogenspannungsberechnung ist in Figur 4 dargestellt.

Figur 4 zeigt eine Darstellung, bei der die ermittelte Spannung U und die ermittelte Stromgröße I des Stromkreises, durch nicht dargestellte Spannungs- und Stromsensoren, einer ersten Auswerteeinheit AE zugeführt werden. Die Spannung U wird einer ersten Störlichtbogenerkennungsfunktion SLEF1 und einer zweiten Störlichtbogenerkennungsfunktion SLEF2 zugeführt. Die Stromgröße I wird der zweiten Störlichtbogenfunktion SLEF2 und einer dritten Störlichtbogenfunktion SLEF3 zugeführt.

Die drei Störlichtbogenerkennungsfunktionen SLEF1, SLEF2, SLEF3 ermitteln jeweils nach unterschiedlichen Prinzipien Störlichtbogen bzw. Störlichtbogenkriterien.

Beispielsweise kann die erste Störlichtbogenerkennungsfunktion SLEF1 eine Störlichtbogenerkennung mittels der Teilsummenberechnung respektive W-RU durchführen. Alternativ kann diese auch eine Spannungswert-Differenzenquotientberechnung durchführen.

Beispielsweise kann die zweite Störlichtbogenerkennungsfunktion eine integrierende oder differenzierende Ermittlung der Lichtbogenspannung durchführen.

Beispielsweise kann die dritte Störlichtbogenerkennungsfunktion eine Prüfung hinsichtlich gewisser Strombedingungen durchführen.

Auch andere Kombinationen und Verschachtelungen der genannten Methoden sind denkbar und umfasst.

Wesentlich ist, dass mindestens zwei verschiedene Störlichtbogenerkennungsfunktionen, d.h. zwei verschiedene Methoden Anwendung finden. Optimalerweise können drei oder auch mehr Methoden parallel angewendet werden.

Besonders vorteilhaft hat sich die Kombination aus Teilsummenberechnung/W-RU und integrierender Ermittlung herausgestellt, optimalerweise in Kombination mit der Überstromfreigabe. Hiermit lässt sich eine besonders gute Erkennung von Störlichtbögen erreichen.

Die Ausgänge der ersten beiden Störlichtbogenerkennungsfunktionen SLEF1, SLEF2, die bei erkennen eines Störlichtbogen jeweils ein erstes oder/und zweites Störlichtbogenerkennungssignal SLES1, SLES2 abgeben, sind mit einer ODER-Funktion OF verbunden. Der Ausgang der dritten Störlichtbogenerkennungsfunktionen SLEF 3 und der Ausgang der Oder-Funktion OF sind mit einer Und-Funktion UF verbunden. Dessen Ausgang bildet den Ausgang AUS der Auswerteeinheit AE.

D.h. bei Vorliegen eines ersten oder zweiten Störlichtbogenerkennungssignals SLES1, SLES2 und bei vorliegen eines dritten Störlichtbogenerkennungssignals SLES3 wird am Ausgang der Auswerteinheit AE ein Störlichtbogenerkennungssignal SLES abgegeben.

Die Auswerteinheit muss dabei nicht als geschlossene Baugruppe realisiert sein, sondern kann dezentral aufgebaut sein. Beispielsweise kann sie durch einen Mikroprozessor realisiert sein, der die erfindungsgemäßen Auswertungen durchführt.

Des Weiteren kann die Abgabe eines Störlichtbogenerkennungssignals erst dann erfolgen, wenn mindestens zweimal entsprechende Auswertewerte oder/und das Stromkriterium den entsprechenden Schwellwert überschreitet. Analog kann auch eine dreimalige, viermalige, fünfmalige, usw. Überschreitung des Schwellwertes zur Abgabe eines Störlichtbogenerkennungssignales führen. So wird eine besonders sichere Auswertung und Erkennung eines Störlichtbogens erreicht.

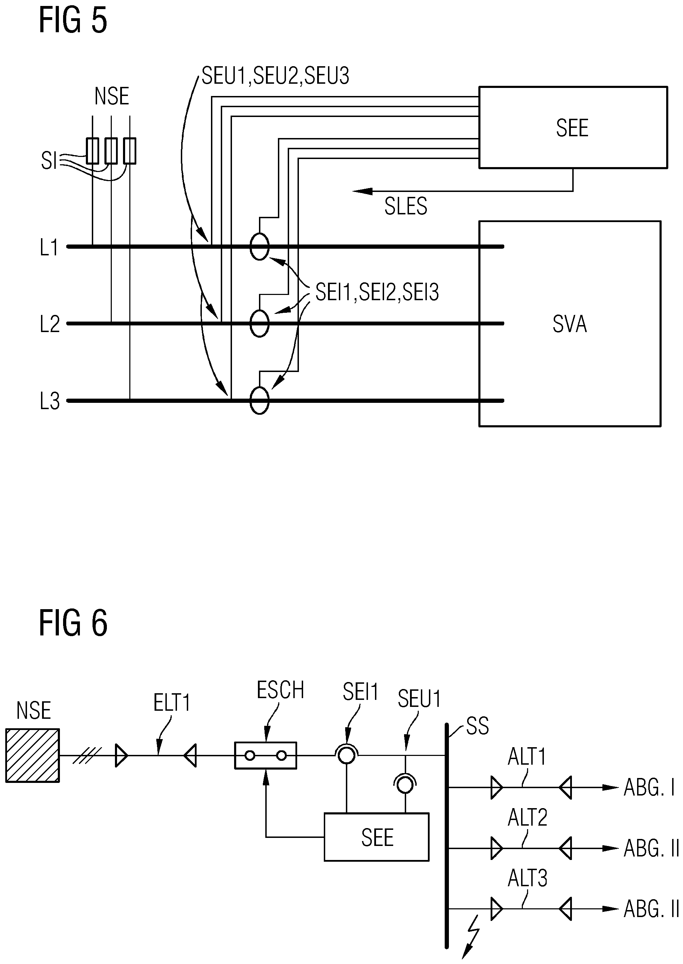

Figur 5 zeigt eine schematische Darstellung eines Übersichtsschaltbildes für eine Anlagenkonfiguration mit abgangsselektiver Störlichtbogenerkennungseinheit für die Erfassung von Störlichtbogen. Figur 5 zeigt eine Niederspannungs-Einspeisung NSE, mit Sicherungen SI, denen Stromschienen bzw. Sammelschienen L1, L2, L3 für die Leiter eines Dreiphasen-Wechselstromnetzes bzw. Stromkreises folgen. Der Neutralleiter bzw. Nullleiter ist nicht dargestellt. Jeder der drei Stromschienen L1, L2, L3 ist jeweils ein Spannungssensor SEU1, SEU2, SEU3 und ein Stromsensor SEI1, SEI2, SEI3 zugeordnet. Die Stromschienen sind mit einer Schalt- oder/und Verteilanlage SVA verbunden.

Die Spannungs- und Stromsensoren sind mit einer erfindungsgemäßen Störlichtbogenerkennungseinheit SEE verbunden, die eine erfindungsgemäße Auswerteeinheit AE aufweist. Diese weist einen Ausgang zur Abgabe eines Störlichtbogenerkennungssignals SLES auf.

Die Spannungs- und Stromsensoren ermitteln Spannungswerte und Stromgrößen (Stromwert oder/und Stromwertänderung) der Sammelschienen L1, L2, L3 und führen sie der erfindungsgemäßen Störlichtbogenerkennungseinheit SEE zu.

Die Sensoren sind dabei außerhalb Störlichtbogenerkennungseinheit angeordnet und mit dieser verbunden.

Figur 6 zeigt eine weitere schematische Darstellung eines Übersichtsschaltbildes für eine Anlagenkonfiguration mit zentraler Störlichtbogenerkennungseinheit für die Erfassung von Störlichtbogen. Figur 6 zeigt eine Niederspannungseinspeisung NSE, der ein Einspeise-Kabel ELT1 folgt, dem ein Einspeise-Schalter ESCH folgt, dem ein Stromsensor SEI1 und ein Spannungssensor SEU1 folgt, dem eine Sammelschien SS folgt. An der Sammelschiene SS sind 3 Abgänge ABG I ABG II und ABG III vorgesehen. Diesen ist je ein Abgangs-Kabel ALT1, ALT2, ALT3 zugeordnet.

Die Sensoren SEII, SEU1 sind mit einer Störlichtbogenerkennungseinheit SEE verbunden, dessen Ausgang wiederum mit dem Einspeise-Schalter ESCH verbunden ist. Der Einspeise-Schalter kann dabei ein Leistungsschalter sein. Bei Erkennung eines Störlichtbogens kann der elektrische Stromkreis, d.h. die Stromversorgung der Sammelschiene SS unterbrochen werden, wenn beispielsweise in einem der Abgänge ein Störlichtbogen auftritt.

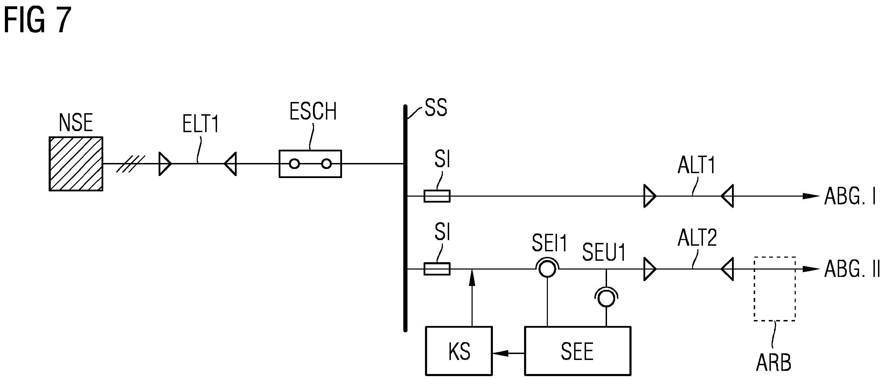

Figur 7 zeigt eine Darstellung gemäß Figur 6, mit dem Unterschied, dass die Sensoren im zweiten Abgang ABG II angeordnet sind, der zudem Sicherungen SI und einen Kurzschließer KS aufweist. Die Sensoren SEI1 und SEU1 erfassen Strom- und Spannungswerte des Abganges ABG II und geben diese an die Störlichtbogenerkennungseinheit SEE weiter. Erkennt die Störlichtbogenerkennungseinheit SEE einen Störlichtbogen, wird an ihrem Ausgang ein Störlichtbogenerkennungssignal SLES abgegeben und zum Kurzschließer KS übertragen. Dieser schließt daraufhin den Abgang ABG II kurz, um den Störlichtbogen zu löschen.

Die Störlichtbogenerkennung gemäß Figur 6 oder 7 kann beispielsweise als mobiles System ausgeführt sein.

Die Erfindung soll im Folgenden nochmals erläutert werden.

Mit der Erfindung können Störlichtbögen, insbesondere parallele oder stromstarke, insbesondere in Niederspannungsschalt- und Verteilungsanlagen, erkannt werden. Erfindungsgemäß steht dazu insbesondere eine nummerischer Lösung bzw. Detektionsalgorithmus auf Grundlage der Auswertung von gemessenen Spannungs- bzw. Stromwerten bzw. -signalen zur Verfügung. Für die Erkennung von Störlichtbögen wird insbesondere die Spannung gemessen und Mithilfe einer erfindungsgemäßen Berechnung ein Störlichtbogen ermittelt. Aufgrund der in der Praxis notwendigen schnellen Lichtbogendetektion kann hierbei erfindungsgemäß eine außerordentlich schnelle zeitliche Auswertung zur Verfügung gestellt werden.

Mit dieser Erfindung können beispielsweise auf Basis einer zentralen Spannungs- bzw. Strommessung an der Einspeisung stromstarke Störlichtbögen, beispielsweise in Schalt- und Verteileranlagen, z.B. in der Niederspannung, schnell detektiert werden.

Die Erfindung kann insbesondere vorteilhaft in bzw. im Zusammenwirken mit Leistungsschaltern oder Kurzschließern eingesetzt werden.

Eine aufwendige Installation von Lichtwellenleitern in Anlagen zur Störlichtbogenerkennung ist nicht erforderlich. Die Spannungs- / Strommessung kann zentral realisiert und ggf. synergetisch von weiteren Betriebsmitteln genutzt werden.

Im Weiteren ist eine Implementierung in vorhandene Schalt- und Verteileranalgen einfach möglich, da ein erfindungsgemäßes Detektionssystem beispielsweise lediglich zentral eingebaut werden kann und keine Installation in einzelnen, zu schützenden Zellen erforderlich ist.

Die Erfindung kann als Baugruppe mit zentraler Spannungs- und Stromermittlung realisiert sein.

Die bisher am Markt etablierten Detektionssysteme basieren auf einer optischen Fehlererkennung und weisen somit Potential zu einer Fehlauslösung durch die Einwirkung von Fremdlicht (z.B. Blitzlicht) auf. Bei der erfindungsgemäßen Lösung auf Grundlage einer Spannungs- bzw. Strommessung ist dieses Gefahrenpotential nicht vorhanden.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.

Bezugszeichenliste

| | |
|---|---|
| A | Ampere |
| ABG I | Abgang I |
| ABG II | Abgang II |
| ABG III | Abgang III |
| AE | Auswerteeinheit |
| AE1 | Erste Auswerte(teil)einheit |
| AE2 | Zweite Auswerte(teil)einheit |
| ALT 1 | Abgangs-Kabel 1 |
| ALT 2 | Abgangs-Kabel 2 |
| ALT 3 | Abgangs-Kabel 3 |
| ARB | Arbeitsbereich |
| AUS | Ausgang |
| ELT1 | Einspeise-Kabel 1 |

| | |
|---|---|
| ESCH | Einspeise-Schalter, Leistungsschalter |
| I | elektrischer Strom / Stromgröße |
| $i_{LB}$ | Lichtbogenstrom |
| $i_m$ | Stromwert, gemessen |
| $i'_m$ | Wert der Änderung des Stromwertes |
| KS | Kurzschließer |
| $L_{BM}$ | Induktivität Verbraucher |
| $L_{EK}$ | Induktivität Einspeise-Kabel |
| L1 | Stromschiene, Leiter 1 |
| L2 | Stromschiene, Leiter 2 |
| L3 | Stromschiene, Leiter 3 |
| ms | Millisekunden |
| NSE | Niederspannungseinspeisung |
| OF | Oder-Funktion |
| $R_{BM}$ | Widerstand Verbraucher |
| $R_{EK}$ | Widerstand Einspeise-Kabel |
| SEE | Störlichtbogenerkennungseinheit |
| SLEF1 | erste Störlichtbogenerkennnungsfunktion |
| SLEF2 | zweite Störlichtbogenerkennungsfunktion |
| SLEF3 | dritte Störlichtbogenerkennungsfunktion |
| SEI1 | Stromsensor |
| SEI2 | Stromsensor |
| SEI3 | Stromsensor |
| SEU1 | Spannungssensor |
| SEU2 | Spannungssensor |
| SEU3 | Spannungssensor |
| SLES | Störlichtbogenerkennungssignal |
| SLES1 | erstes Störlichtbogenerkennungssignal |
| SLES2 | zweites Störlichtbogenerkennungssignal |
| SLES3 | drittes Störlichtbogenerkennungssignal |
| SI | Sicherung |
| SS | Sammelschiene |
| SVA | Schalt- und Verteilanlage |
| SW1 | Schwellwert Lichtbogenspannung |
| SW2 | Schwellwert Lichtbogenspannung |
| SW3 | Schwellwert Stromfreigabe |
| SW4 | Schwellwert Spannungsdifferenzenquotient |
| SW5 | fünfter Schwellwert |
| SW6 | sechster Schwellwert |
| t | Zeit |
| U | elektrische Spannung |
| UF | Und-Funktion |
| $U_{LB}$ | Lichtbogenspannung |
| $u_m$ | Spannungswert, gemessen |
| $u_n$ | Spannungswert, Energiequelle / Netz |
| V | Volt |
| & | UND-Einheit |
| 1 | Schritt 1 - fortlauf. Berechnung |
| 2 | Schritt 2 - Schwellwertvergleich |
| 3 | Schritt 3 - Abgabe Störlichtbogenerkennungssignal |
| 4 | Schritt 4 - Kein Störlichtbogen |
| 100 | Energiequelle |
| 200 | Netzzugang / Einspeise-Kabel |
| 300 | Verbraucher / Betriebsmittel / Energiesenke |
| 400 | Lichtbogen |
| 500 | Überwachter Bereich |
| 600 | Meßpunkte |

**Patentansprüche**

1. Störlichtbogenerkennungseinheit für einen elektrischen Niederspannungswechselstromkreis, aufweisend

   eine Auswerteeinheit,
   mindestens einen dem Stromkreis zugeordneten Spannungssensor, zur periodischen Ermittlung von elektrischen Spannungswerten des elektrischen Stromkreises,
   mindestens einen dem Stromkreis zugeordneten Stromsensor, zur periodischen Ermittlung von elektrischen Stromgrößen des Stromkreises,
   die beide mit der Auswerteeinheit verbunden sind, wobei die Auswerteeinheit derart ausgestaltet ist,
   dass die elektrischen Spannungswerte einer ersten Störlichtbogenerkennungsfunktion zugeführt werden, die an Hand des Signalverlaufs der Spannung eine erste Störlichtbogenerkennung durchführt und bei betragsmäßiger Überschreitung eines die Änderung der Spannung nach der Zeit betreffenden Schwellwertes (SW1, SW4) ein erstes Störlichtbogenerkennungssignal abgibt,
   dass die elektrischen Spannungswerte und Stromgrößen einer zweiten Störlichtbogenerkennungsfunktion zugeführt werden, die an Hand der Spannungswerte und Stromgrößen eine zweite Störlichtbogenerkennung durchführt, wobei die zweite Lichtbogenerkennungsfunktion fortlaufend eine Lichtbogenspannung ($U_{LB}$) mit Hilfe der ermittelten Spannungswerte und der ermittelten Stromgrößen berechnet und bei betragsmäßiger Überschreitung eines zweiten, die Lichtbogenspannung betreffenden Schwellwertes (SW2) ein zweites Störlichtbogenerkennungssignal abgibt,
   dass die beiden Störlichtbogenerkennungssignale einer Oder-Funktion zugeführt werden, so dass bei Vorliegen eines ersten oder zweiten Störlichtbogenerkennungssignales ein oderverknüpftes Störlichtbogenerkennungssignal als ausgangsseitiges Störlichtbogenerkennungssignal abgegeben wird,
   dass die Auswerteeinheit derart ausgestaltet ist,
   dass die elektrischen Stromgrößen einer dritten Störlichtbogenerkennungsfunktion zugeführt werden, die fortlaufend die Stromgröße oder deren Äquivalent mit einem dritten Schwellwert (SW3) vergleicht und bei dessen Überschreitung ein drittes Störlichtbogenerkennungssignal abgibt, und
   dass das oderverknüpfte Störlichtbogenerkennungssignal und
   das dritte Störlichtbogenerkennungssignal einer Und-Funktion zugeführt werden, so dass das ausgangsseitige Störlichtbogenerkennungssignal nur bei Vorliegen des dritten und des oderverknüpften Störlichtbogenerkennungssignales von der Störlichtbogenerkennungseinheit abgegeben wird.

2. Störlichtbogenerkennungseinheit gemäß einem der vorhergehenden Patentansprüche,
   **dadurch gekennzeichnet,**
   **dass** die elektrischen Spannungswerte oder/und Stromgrößen mit einem festen Zeitabstand (dt) ermittelt werden.

3. Störlichtbogenerkennungseinheit gemäß einem der vorhergehenden Patentansprüche,
   **dadurch gekennzeichnet,**

   **dass** die erste Störlichtbogenerkennungsfunktion fortlaufend eine erste Hälfte einer ersten Anzahl Spanungswerte zu einer ersten Teilsumme (TS1) und die zweite Hälfte an Spannungswerten zu einer zweiten Teilsumme (TS2) aufsummiert,
   eine Differenz (DU) beider Teilsummen ermittelt wird,
   **dass** die Differenz (DU) mit einem ersten die Änderung der Spannung nach Zeit betreffenden Schwellwert (SW1) verglichen wird und bei dessen betragsmäßiger Überschreitung ein erstes Störlichtbogenerkennungssignal (SLES1) abgegeben wird.

4. Störlichtbogenerkennungseinheit gemäß einem der vorhergehenden Patentansprüche 1 oder 2,
   **dadurch gekennzeichnet,**
   **dass** die erste Störlichtbogenerkennungsfunktion fortlaufend aus zwei zeitlich aufeinanderfolgenden Spannungswerten eine Spannungsdifferenz ermittelt, die Spannungsdifferenz durch die zeitliche Differenz der Spannungswerte dividiert wird, der daraus ermittelte Differenzenquotient als Maß für die Änderung der Spannung nach der Zeit mit einem vierten die Änderung der Spannung nach Zeit betreffenden Schwellwert (SW4) verglichen wird und bei dessen betragsmäßiger Überschreitung das erste Störlichtbogenerkennungssignal abgegeben wird.

5. Störlichtbogenerkennungseinheit gemäß einem der vorhergehenden Patentansprüche,
   **dadurch gekennzeichnet,**
   **dass** als elektrische Stromgröße entweder ein elektrischer Stromwert ($i_m$) oder/und ein Wert für die Änderung des elektrischen Stromes nach der Zeit ($i'_m$) ermittelt wird.

**6.** Störlichtbogenerkennungseinheit nach Patentanspruch 5, **dadurch gekennzeichnet,**

**dass** im Falle der Ermittlung des elektrischen Stromwertes ($i_m$) daraus ein Wert für die Änderung des elektrischen Stromes nach der Zeit ($i'_m$) ermittelt wird oder
**dass** im Falle der Ermittlung des Wertes für die Änderung des elektrischen Stromes nach der Zeit ($i'_m$) daraus der elektrische Stromwert ($i_m$) ermittelt wird,
so dass ein Wertepaar einen Spannungswert ($u_m$), einen Stromwert ($i_m$) und einen Wert für die Änderung des Stromes nach der Zeit ($i'_m$) aufweist.

**7.** Störlichtbogenerkennungseinheit gemäß Patentanspruch 5 oder 6,
**dadurch gekennzeichnet,**
**dass** die zweite Störlichtbogenerkennungsfunktion fortlaufend aus mindestens zwei Wertepaaren die Lichtbogenspannung ($U_{LB}$) berechnet, die mit dem zweiten Schwellwert (SW2) verglichen wird und bei dessen betragsmäßiger Überschreitung das zweite Störlichtbogenerkennungssignal abgegeben wird.

**8.** Störlichtbogenerkennungseinheit gemäß Patentanspruch 7,
**dadurch gekennzeichnet,**
**dass** die zweite Störlichtbogenerkennungsfunktion fortlaufend aus drei Wertepaaren die Lichtbogenspannung ($U_{LB}$) berechnet.

**9.** Störlichtbogenerkennungseinheit gemäß Patentanspruch 7 oder 8,
**dadurch gekennzeichnet,**
**dass** die zweite Störlichtbogenfunktion derart ausgestaltet ist, dass die Berechnung der Lichtbogenspannung ($U_{LB}$) mittels einer Differentialgleichung oder deren Lösung durchgeführt wird.

**10.** Störlichtbogenerkennungseinheit gemäß Patentanspruch 5 oder 6,
**dadurch gekennzeichnet,**
**dass** ein Wertesatz mehrere Wertepaare ($t_s$) umfasst und dass die zweite Störlichtbogenerkennungsfunktion fortlaufend aus mindestens zwei Wertesätzen die Lichtbogenspannung ($U_{LB}$) berechnet, die mit dem zweiten Schwellwert (SW2) verglichen wird und bei dessen betragsmäßiger Überschreitung das zweite Störlichtbogenerkennungssignal abgegeben wird.

**11.** Störlichtbogenerkennungseinheit gemäß Patentanspruch 10,
**dadurch gekennzeichnet,**
**dass** die zweite Störlichtbogenerkennungsfunktion fortlaufend aus drei Wertesätzen die Lichtbogenspannung ($U_{LB}$) berechnet.

**12.** Störlichtbogenerkennungseinheit nach Patentanspruch 10 oder 11,
**dadurch gekennzeichnet,**
**dass** die zweite Störlichtbogenfunktion derart ausgestaltet ist, dass die Berechnung der Lichtbogenspannung ($U_{LB}$) mittels einer Integralgleichung oder deren Lösung durchgeführt wird.

**13.** Leistungsschalter für einen elektrischen Niederspannungsstromkreis, aufweisend eine Störlichtbogenerkennungseinheit gemäß einem der Patentansprüche 1 bis 12, die mit dem Leistungsschalter verbunden ist und die derart ausgestaltet sind, dass bei Abgabe eines ausgangsseitigen Störlichtbogenerkennungssignals der Leistungsschalter auslöst, um den elektrischen Stromkreis zu unterbrechen.

**14.** Kurzschließer, aufweisend eine Störlichtbogenerkennungseinheit gemäß einem der Patentansprüche 1 bis 12, die mit dem Kurzschließer verbunden ist, und die derart ausgestaltet sind, dass bei Abgabe eines ausgangsseitigen Störlichtbogenerkennungssignals der Kurzschließer den elektrischen Stromkreis kurzschließt, um ein Löschen des Störlichtbogen zu bewirken.

**15.** Verfahren zur Störlichtbogenerkennung für einen elektrischen Niederspannungswechselstromkreis,

bei dem periodisch elektrische Spannungswerte und Stromgrößen des elektrischen Stromkreises ermittelt werden,

wobei die elektrischen Spannungswerte einer ersten Störlichtbogenerkennungsfunktion zugeführt werden, die an Hand des Signalverlaufs der Spannung eine erste Störlichtbogenerkennung durchführt und bei betragsmäßiger Überschreitung eines die Änderung des Spannung nach der Zeit betreffenden Schwellwertes (SW1, SW4) ein erstes Störlichtbogenerkennungssignal abgibt,

wobei die elektrischen Spannungswerte und Stromgrößen einer zweiten Störlichtbogenerkennungsfunktion zugeführt werden, die an Hand der Spannungswerte und Stromgrößen eine zweite Störlichtbogenerkennung durchführt, wobei die zweite Störlichtbogenerkennungsfunktion eine Lichtbogenspannung ($U_{LB}$) mit Hilfe der Spannungswerte und der Stromgrößen berechnet und bei betragsmäßiger Überschreitung eines zweiten, die Lichtbogenspannung betreffenden Schwellwertes (SW2) ein zweites Störlichtbogenerkennungssignal abgibt,

wobei die beiden Störlichtbogenerkennungssignale einer Oder-Funktion zugeführt werden, so dass bei Vorliegen eines ersten oder zweiten Störlichtbogenerkennungssignales ein oderverknüpftes Störlichtbogenerkennungssignal als ausgangsseitiges Störlichtbogenerkennungssignal abgegeben wird,

wobei die elektrischen Stromgrößen einer dritten Störlichtbogenerkennungsfunktion zugeführt werden, die fortlaufend die Stromgröße oder deren Äquivalent mit einem dritten Schwellwert (SW3) vergleicht und bei dessen Überschreitung ein drittes Störlichtbogenerkennungssignal abgibt, und

wobei das oderverknüpfte Störlichtbogenerkennungssignal und das dritte Störlichtbogenerkennungssignal einer Und-Funktion zugeführt werden, so dass das ausgangsseitige Störlichtbogenerkennungssignal nur bei Vorliegen des dritten und des oderverknüpften Störlichtbogenerkennungssignales von der Störlichtbogenerkennungseinheit abgegeben wird.

## Claims

1. Arc fault detection unit for an electrical low-voltage AC circuit, having

    an evaluation unit,
    at least one voltage sensor assigned to the circuit, for periodically determining electric voltage values of the electrical circuit,
    at least one current sensor assigned to the circuit, for periodically determining electric current variables of the circuit,
    both of which are connected to the evaluation unit, wherein the evaluation unit is configured in such a way
    that the electric voltage values are fed to a first arc fault detection function, which carries out a first arc fault detection on the basis of the signal profile of the voltage and, if a threshold value (SW1, SW4), which relates to the change in the voltage over the time, is exceeded in magnitude, outputs a first arc fault detection signal,
    that the electric voltage values and current variables are fed to a second arc fault detection function, which carries out a second arc fault detection on the basis of the voltage values and current variables, wherein the second arc detection function continuously calculates an arc voltage ($U_{Lb}$) with the aid of the determined voltage values and the determined current variables, and, if a second threshold value (SW2), which relates to the arc voltage, is exceeded in magnitude, outputs a second arc fault detection signal,
    that the two arc fault detection signals are fed to an OR function so that, in the presence of a first or second arc fault detection signal, an OR-linked arc fault detection signal is output as an output-side arc fault detection signal,
    that the evaluation unit is configured in such a way that the electric current variables are fed to a third arc fault detection function, which continuously compares the current variable or the equivalent thereof with a third threshold value (SW3) and, if said third threshold value is exceeded, outputs a third arc fault detection signal, and
    that the OR-linked arc fault detection signal and the third arc fault detection signal are fed to an AND function so that the output-side arc fault detection signal is output by the arc fault detection unit only in the presence of the third and the OR-linked arc fault detection signal.

2. Arc fault detection unit according to either of the preceding patent claims,
    **characterized**
    **in that** the electric voltage values and/or current variables are determined with a fixed time interval (dt).

3. Arc fault detection unit according to either of the preceding patent claims,
    **characterized**

    **in that** the first arc fault detection function continuously sums a first half of a first number of voltage values to form a first partial sum (TS1) and the second half of voltage values to form a second partial sum (TS2),
    a difference (DU) of the two partial sums is determined,

**in that** the difference (DU) is compared with a first threshold value (SW1), which relates to the change in the voltage over time and, if said first threshold value is exceeded in magnitude, a first arc fault detection signal (SLES1) is output.

4. Arc fault detection unit according to one of the preceding Patent Claims 1 or 2, **characterized in that** the first arc fault detection function continuously determines a voltage difference from two temporally successive voltage values, the voltage difference is divided by the temporal difference of the voltage values, the difference quotient determined therefrom as measure for the change in the voltage over the time is compared with a fourth threshold value (SW4), which relates to the change in the voltage over time and, if said fourth threshold value is exceeded in magnitude, the first arc fault detection signal is output.

5. Arc fault detection unit according to one of the preceding patent claims, **characterized in that** either an electric current value ($i_m$) and/or a value for the change in the electric current over the time ($i'_m$) is determined as electric current variable.

6. Arc fault detection unit according to Patent Claim 5, **characterized**

   **in that**, in the case of the electric current value ($i_m$) being determined, a value for the change in the electric current over the time ($i'_m$) is determined therefrom or
   **in that**, in the case of the value for the change in the electric current over the time ($i'_m$) being determined, the electric current value ($i_m$) is determined therefrom,
   so that a value pair has a voltage value ($u_m$), a current value ($i_m$) and a value for the change in the current over the time ($i'_m$).

7. Arc fault detection unit according to Patent Claim 5 or 6, **characterized in that** the second arc fault detection function continuously calculates the arc voltage ($U_{LB}$) from at least two value pairs, which arc voltage is compared with the second threshold value (SW2) and, if said second threshold value is exceeded in magnitude, the second arc fault detection signal is output.

8. Arc fault detection unit according to Patent Claim 7, **characterized in that** the second arc fault detection function continuously calculates the arc voltage ($U_{LB}$) from three value pairs.

9. Arc fault detection unit according to Patent Claim 7 or 8, **characterized in that** the second arc fault function is configured in such a way that the calculation of the arc voltage ($U_{LB}$) is carried out by means of a differential equation or the solution thereof.

10. Arc fault detection unit according to Patent Claim 5 or 6, **characterized in that** a value set comprises a plurality of value pairs ($t_s$) and in that the second arc fault detection function continuously calculates the arc voltage ($U_{LB}$) from at least two value sets, which arc voltage is compared with the second threshold value (SW2) and, if said second threshold value is exceeded in magnitude, the second arc fault detection signal is output.

11. Arc fault detection unit according to Patent Claim 10, **characterized in that** the second arc fault detection function continuously calculates the arc voltage ($U_{LB}$) from three value sets.

12. Arc fault detection unit according to Patent Claim 10 or 11, **characterized in that** the second arc fault function is configured in such a way that the calculation of the arc voltage ($U_{LB}$) is carried out by means of an integral equation or the solution thereof.

13. Circuit breaker for an electrical low-voltage circuit, having an arc fault detection unit according to one of Patent Claims 1 to 12, which is connected to the circuit breaker, and which are configured in such a way that, when an output-side arc fault detection signal is output, the circuit breaker trips in order to interrupt the electrical circuit.

14. Short-circuiting device, having an arc fault detection unit according to one of Patent Claims 1 to 12, which is connected to the short-circuiting device, and which are configured in such a way that, when an output-side arc fault detection signal is output, the short-circuiting device short-circuits the electrical circuit in order to cause extinguishing of the arc fault.

15. Method for arc fault detection for an electrical low-voltage AC circuit,

in which electric voltage values and current variables of the electrical circuit are determined periodically, wherein the electric voltage values are fed to a first arc fault detection function, which carries out a first arc fault detection on the basis of the signal profile of the voltage and, if a threshold value (SW1, SW4), which relates to the change in the voltage over the time, is exceeded in magnitude, outputs a first arc fault detection signal, wherein the electric voltage values and current variables are fed to a second arc fault detection function, which carries out a second arc fault detection on the basis of the voltage values and current variables, wherein the second arc fault detection function calculates an arc voltage ($U_{Lb}$) with the aid of the voltage values and the current variables, and, if a second threshold value (SW2), which relates to the arc voltage, is exceeded in magnitude, outputs a second arc fault detection signal, wherein the two arc fault detection signals are fed to an OR function so that, in the presence of a first or second arc fault detection signal, an OR-linked arc fault detection signal is output as an output-side arc fault detection signal, wherein the electric current variables are fed to a third arc fault detection function, which continuously compares the current variable or the equivalent thereof with a third threshold value (SW3) and, if said third threshold value is exceeded, outputs a third arc fault detection signal, and wherein the OR-linked arc fault detection signal and the third arc fault detection signal are fed to an AND function so that the output-side arc fault detection signal is output by the arc fault detection unit only in the presence of the third and the OR-linked arc fault detection signal.

**Revendications**

1. Unité de détection d'arc électrique parasite destinée à un circuit électrique de courant alternatif basse tension, présentant :

une unité d'évaluation, au moins un capteur de tension associé au circuit de courant, pour une détermination périodique de valeurs de tension électrique du circuit de courant électrique, au moins un capteur d'intensité associé au circuit de courant, pour une détermination périodique de grandeurs d'intensité électriques du circuit de courant, les deux capteurs étant reliés à l'unité d'évaluation, dans lequel l'unité d'évaluation est configurée de telle sorte que :

les valeurs de tension électrique sont fournies à une première fonction de détection d'arc électrique parasite, qui exécute une première détection d'arc électrique parasite sur la base de la forme d'onde de la tension, et en cas de dépassement par le haut en amplitude d'une valeur seuil (SW1, SW4) concernant la modification de la tension après le temps, émet un premier signal de détection d'arc électrique parasite, les valeurs électriques de tension et les grandeurs d'intensité sont fournies à une deuxième fonction de détection d'arc électrique parasite, qui exécute une deuxième détection d'arc électrique parasite sur la base des valeurs de tension et des grandeurs d'intensité, dans lequel la deuxième fonction de détection d'arc électrique parasite calcule en continu une tension d'arc électrique ($U_{LB}$) à l'aide des valeurs de tension déterminées et des grandeurs d'intensité déterminées, et, en cas de dépassement par le haut en amplitude d'une deuxième valeur seuil (SW2) concernant la tension d'arc électrique, émet un deuxième signal de détection d'arc électrique parasite, les deux signaux de détection d'arc électrique parasite sont fournis à une fonction OU, de telle manière qu'en présence d'un premier ou d'un deuxième signal de détection d'arc électrique parasite, un signal de détection d'arc électrique parasite émis par la fonction OU est délivré à titre de signal de détection d'arc électrique parasite du côté sortie, et l'unité d'évaluation est configurée de telle sorte que :

les grandeurs d'intensité électriques sont fournies à une troisième fonction de détection d'arc électrique parasite, qui compare en continu la grandeur d'intensité ou son équivalent à une troisième valeur seuil (SW3), et, en cas de dépassement par le haut de celle-ci, délivre un troisième signal de détection d'arc électrique parasite, et

le signal de détection d'arc électrique parasite émis par la fonction OU et le troisième signal de détection d'arc électrique parasite sont fournis à une fonction ET, de telle sorte que le signal de détection d'arc électrique parasite du côté sortie est délivré par l'unité de détection d'arc électrique parasite uniquement en présence du troisième signal et du signal de détection d'arc électrique parasite émis par la fonction OU.

2. Unité de détection d'arc électrique parasite selon la revendication précédente,
**caractérisée en ce que** les valeurs de tension et/ou les grandeurs d'intensité électriques sont déterminées à un intervalle de temps fixe (dt).

3. Unité de détection d'arc électrique parasite selon l'une des revendications précédentes,
**caractérisée**

**en ce que** la première fonction de détection d'arc électrique parasite additionne en continu une première moitié d'un premier nombre de valeurs de tension pour obtenir une première somme partielle (TS1) et la deuxième moitié des valeurs de tension pour obtenir une deuxième somme partielle (TS2),
une différence (DU) des deux sommes partielles est déterminée, et
**en ce que** la différence (DU) est comparée avec une première valeur seuil (SW1) concernant la modification de la tension après le temps et en cas de dépassement par le haut en amplitude de celle-ci, un premier signal de détection d'arc électrique parasite (SLES1) est délivré.

4. Unité de détection d'arc électrique parasite selon l'une des revendications précédentes 1 ou 2,
**caractérisée**
**en ce que** la première fonction de détection d'arc électrique parasite détermine en continu une différence de tension à partir de deux valeurs de tension consécutives dans le temps, la différence de tension est divisée par la différence temporelle des valeurs de tension, et le quotient de différences obtenu à partir de celles-ci, à titre de mesure de la modification de tension après le temps, est comparé à une quatrième valeur seuil (SW4) concernant la modification de la tension après le temps et en cas de dépassement par le haut en amplitude de celle-ci, le premier signal de détection d'arc électrique parasite est émis.

5. Unité de détection d'arc électrique parasite selon l'une des revendications précédentes,
**caractérisée**
**en ce qu'**à titre de grandeur d'intensité électrique, une valeur d'intensité électrique ($i_m$) ou/et une valeur de la modification d'intensité électrique après le temps ($i'_m$) est déterminée.

6. Unité de détection d'arc électrique parasite selon la revendication 5,
**caractérisée**

**en ce que** dans le cas de détermination de la valeur d'intensité électrique ($i_m$), il est déterminé à partir de celle-ci une valeur de la modification de l'intensité électrique après le temps ($i'_m$) ou
**en ce que** dans le cas de détermination de la valeur de modification d'intensité électrique après le temps ($i'_m$), il est déterminé à partir de celle-ci la valeur d'intensité électrique ($i_m$),
de telle manière qu'un couple de valeurs présente une valeur de tension ($U_m$), une valeur d'intensité ($i_m$) et une valeur de la modification d'intensité après le temps ($i'_m$).

7. Unité de détection d'arc électrique parasite selon la revendication 5 ou 6,
**caractérisée en ce que** la deuxième fonction de détection d'arc électrique parasite calcule en continu, à partir d'au moins deux couples de valeurs, la tension d'arc électrique ($U_{LB}$), laquelle est comparée à la deuxième valeur seuil (SW2), et en cas de dépassement en amplitude de celle-ci, le deuxième signal de détection d'arc électrique parasite est émis.

8. Unité de détection d'arc électrique parasite selon la revendication 7,
**caractérisée en ce que** la deuxième fonction de détection d'arc électrique parasite calcule en continu la tension d'arc électrique ($U_{LB}$) à partir de trois couples de valeurs.

**9.** Unité de détection d'arc électrique parasite selon la revendication 7 ou 8, **caractérisée en ce que** la deuxième fonction de détection d'arc électrique parasite est configurée de sorte que le calcul de la tension d'arc électrique ($U_{LB}$) est exécuté au moyen d'une équation différentielle ou de sa résolution.

**10.** Unité de détection d'arc électrique parasite selon la revendication 5 ou 6, **caractérisée en ce qu'**un ensemble de valeurs comprend plusieurs couples de valeurs ($t_s$) et **en ce que** la deuxième fonction de détection d'arc électrique parasite calcule en continu la tension d'arc électrique ($U_{LB}$) à partir d'au moins deux ensembles de valeurs, laquelle est comparée à la deuxième valeur seuil (SW2) et en cas de dépassement par le haut de celle-ci en amplitude, le deuxième signal de détection d'arc électrique parasite est émis.

**11.** Unité de détection d'arc électrique parasite selon la revendication 10, **caractérisée en ce que** la deuxième fonction de détection d'arc électrique parasite calcule en continu la tension d'arc électrique ($U_{LB}$) à partir de trois ensembles de valeurs.

**12.** Unité de détection d'arc électrique parasite selon la revendication 10 ou 11, **caractérisée en ce que** la deuxième fonction de détection d'arc électrique parasite est configurée de sorte que le calcul de la tension d'arc électrique ($U_{LB}$) est exécuté au moyen d'une équation intégrale ou de sa résolution.

**13.** Commutateur de puissance pour un circuit de courant électrique à basse tension, présentant une unité de détection d'arc électrique parasite selon l'une des revendications 1 à 12, qui est connectée au commutateur de puissance et qui est configurée de telle sorte qu'en cas d'émission d'un signal de détection d'arc électrique parasite côté sortie, l'interrupteur de puissance déclenche pour couper le circuit de courant électrique.

**14.** Court-circuiteur, présentant une unité de détection d'arc électrique parasite selon l'une des revendications 1 à 12, qui est connectée au court-circuiteur, et qui est configurée de telle sorte que lors de l'émission d'un signal de détection d'arc électrique parasite côté sortie, le court-circuiteur court-circuite le circuit de courant électrique, afin d'engendrer une extinction de l'arc électrique parasite.

**15.** Procédé de détection d'arc électrique parasite pour un circuit électrique de courant alternatif basse tension,

dans lequel des valeurs de tension et des grandeurs d'intensité électriques du circuit de courant électrique sont déterminées périodiquement,

dans lequel les valeurs de tension électrique sont fournies à une première fonction de détection d'arc électrique parasite, qui exécute une première détection d'arc électrique parasite sur la base de la forme d'onde de la tension, et en cas de dépassement par le haut en amplitude d'une valeur seuil (SW1, SW4) concernant la modification de la tension après le temps, émet un premier signal de détection d'arc électrique parasite,

les valeurs de tension et les grandeurs d'intensité électriques sont fournies à une deuxième fonction de détection d'arc électrique parasite, qui exécute une deuxième détection d'arc électrique parasite sur la base des valeurs de tension et des grandeurs d'intensité,

dans lequel la deuxième fonction de détection d'arc électrique parasite calcule une tension d'arc électrique ($U_{LB}$) à l'aide des valeurs de tension et des grandeurs d'intensité, et, en cas de dépassement par le haut en amplitude d'une deuxième valeur seuil (SW2) concernant la tension d'arc électrique, émet un deuxième signal de détection d'arc électrique parasite,

dans lequel les deux signaux de détection d'arc électrique sont fournis à une fonction OU, de telle manière qu'en présence d'un premier ou d'un deuxième signal de détection d'arc électrique parasite, un signal de détection d'arc électrique parasite émis par la fonction OU est émis à titre de signal de détection d'arc électrique parasite du côté sortie,

dans lequel les grandeurs d'intensité électriques sont fournies à une troisième fonction de détection d'arc électrique parasite, qui compare en continu la grandeur d'intensité ou son équivalent à une troisième valeur seuil (SW3) et, en cas de dépassement par le haut de celle-ci, émet un troisième signal de détection d'arc électrique parasite, et

dans lequel le signal de détection d'arc électrique parasite émis par la fonction OU et le troisième signal de détection d'arc électrique parasite sont fournis à une fonction ET, de telle sorte que le signal de détection d'arc électrique parasite du côté sortie est émis par l'unité de détection d'arc électrique parasite uniquement en présence du troisième signal et du signal de détection d'arc électrique parasite émis par la fonction OU.

## FIG 1

## FIG 2

FIG 3

FIG 4

EP 3 446 386 B1

## FIG 5

## FIG 6

FIG 7

EP 3 446 386 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110019444 A1
- US 6654219 B1
- WO 2009156513 A1
- US 20080129307 A1